# EUROPEAN PATENT APPLICATION

(11) **EP 4 770 381 A1**
(43) Date of publication of application: **01.07.2026**
(21) Application number: 25218737.2
(22) Date of filing: 26.11.2025
(51) Int. Cl.: H10K 59/131, H10K 59/80, H10K 59/124, H10K 59/40

(54) **DISPLAY APPARATUS**

(30) Priority: 27.12.2024 KR 20240198414
(71) Applicant: LG Display Co., Ltd., Seoul, 07336 (KR)
(72) Inventor: CHO, BeumSik, 10845 Paju-si (KR); KIM, Jaehyoung, 10845 Paju-si (KR); LEE, Dongwoo, 10845 Paju-si (KR)
(74) Representative: Ter Meer Steinmeister & Partner

(57) **Abstract**

A display apparatus includes a substrate having a display area with a hole part, a hole bezel area adjacent to the hole part, and a non-display area adjacent to the display area. A buffer layer is disposed on the substrate, and a pixel circuit layer including a pixel circuit and a pixel insulating layer is formed on the buffer layer in the display area. An overcoat layer covers the pixel circuit layer, and a light emitting device layer including a light emitting device is disposed on the overcoat layer. A crack stopper is disposed in the hole bezel area to surround the hole part and is configured to form a vertical wall between the substrate and the overcoat layer, thereby preventing crack propagation toward the display area and improving structural stability and display reliability.

## Description

This application claims priority to Korean Patent Application No. 10-2024-0198414 filed on December 27, 2024.

### BACKGROUND

### Technical Field

The disclosure relates to a display apparatus.

### Description of the Related Art

Display apparatuses are equipped in home appliances or electronic devices such as televisions (TVs), monitors, notebook computers, smartphones, tablet personal computers (PCs), electronic pads, wearable devices, watch phones, portable information devices, navigation devices, and vehicle control display apparatus, or the like, and are used as a screen for displaying an image.

Recently, display apparatuses have been diversifying in their uses. In addition, the thickness of display apparatuses is becoming thinner and the weight lighter, and the range of their use is becoming broader. Among display apparatuses, as the area occupied by the display region is expanded, various functions integrated or linked with the display apparatuses are being added. As a method to expand the area of the display area and to add various functions, research and development are being continued on using some areas of the display area for a function (or for purposes) other than an image display function.

### BRIEF SUMMARY

The display apparatus described includes holes in the active display area for cameras or sensors while preserving structural integrity and display quality. The design incorporates a crack stopper surrounding the hole to prevent cracks from spreading through display layers, along with barrier structures using undercut and eave geometries to block moisture and oxygen from reaching sensitive organic layers. In addition, dam structures are used to prevent encapsulation materials from flowing into the hole area during manufacturing, protecting the functional layers of the display.

The configuration also addresses electrical and optical defects caused by static charges or mechanical stress. The crack stopper, connected through a stopper power line to ground or a power terminal, dissipates friction charges to prevent unintended bright spots around the hole. Crack detection electrodes integrated with the driving circuit enable real time monitoring of cracks by measuring changes in resistance, allowing predictive maintenance and improved reliability.

The apparatus further employs multi layered buffer structures for stress isolation, integrates touch sensing layers with crack detection components for efficient use of space, and reduces the bezel width to increase the active display area. These combined features allow the display to accommodate cameras or sensors within the display area while maintaining durability, visual quality, and environmental protection.

For example, one or more aspects of the disclosure are directed to providing a display apparatus having a hole configured in a display area.

It is an object to to provide a display apparatus capable of blocking the propagation of cracks generated at a periphery of a hole configured in a display area and preventing brightness defects (or bright spot defects) in a bezel area of the hole.

It is an object to to provide a display apparatus capable of detecting cracks generated at a periphery of a hole configured in a display area.

It is an object to to provide a display apparatus capable of preventing moisture permeation and color abnormalities in a bezel area of a substrate.

It is an object to to provide a display apparatus capable of detecting cracks generated at the periphery of a hole configured in a display area and in a bezel area of a substrate, blocking the propagation of the cracks, preventing moisture permeation and color abnormalities in the bezel area of the substrate, and preventing brightness defects (or bright spot defects) in the bezel area of the hole.

Additional features, advantages, and aspects of the disclosure are set forth in part in the present disclosure and will also be apparent from the present disclosure or may be learned by practice of the inventive concepts provided herein. Other features, advantages, and aspects of the present disclosure may be realized and attained by the descriptions provided in the present disclosure, or derivable therefrom, and claims hereof as well as the appended drawings.

The object is solved by the features of the independent claims. Preferred embodiments are given in the dependent claims.

To achieve these and other advantages and aspects of the disclosure, as embodied and broadly described herein, in one or more aspects, a display apparatus comprises a substrate having a display area including a hole part and a hole bezel area adjacent to the hole part, and a non-display area adjacent to the display area; a buffer layer disposed on the substrate; a pixel circuit layer including a pixel circuit disposed on the buffer layer in the display area and a pixel insulating layer insulating the pixel circuit; an overcoat layer covering the pixel circuit layer; a light emitting device layer including a light emitting device disposed on the overcoat layer; and a crack stopper disposed in the hole bezel area of the substrate so as to surround the hole part. The crack stopper is configured to form a vertical wall between the substrate and the overcoat layer.

In one or more embodiments, the crack stopper may comprise a first stopper pattern disposed on the substrate, and a second stopper pattern penetrating the pixel insulating layer and electrically connected to the first stopper pattern.

In one or more embodiments, the display apparatus may comprise a light shielding pattern disposed between the substrate and the buffer layer.

In one or more embodiments, the first stopper pattern may be formed of a same metal material as the light shielding pattern.

In one or more embodiments, the pixel circuit layer may comprise a plurality of thin film transistors including an active layer, a gate electrode, and source and drain electrodes disposed on the buffer layer.

In one or more embodiments, the pixel insulating layer may comprise a first insulating layer covering the active layer, a second insulating layer covering the gate electrode, and a third insulating layer covering the source and drain electrodes.

In one or more embodiments, the second stopper pattern may be disposed on the third insulating layer.

In one or more embodiments, the second stopper pattern may be formed of a same metal material as the source electrode.

In one or more embodiments, the second stopper pattern may be configured to form the vertical wall between the substrate and the third insulating layer.

In one or more embodiments, the display apparatus may further comprise a crack detection part configured to detect cracks generated in the hole bezel area of the substrate.

In one or more embodiments, the display apparatus may further comprise an encapsulation part covers the light emitting device layer.

In one or more embodiments, the display apparatus may further comprise a touch sensing part disposed on the encapsulation part in the display area.

In one or more embodiments, the crack detection part may disposed on the encapsulation part in the hole bezel area together with the touch sensing part.

In one or more embodiments, the crack detection part may include one end, the other end, and a crack detection electrode between the one end and the other end.

In one or more embodiments, the hole part may be a through hole configured to penetrate the substrate, the buffer layer, the pixel circuit layer, the overcoat layer, the light emitting device layer, the encapsulation part, and the touch sensing part.

In one or more embodiments, the crack detection electrode may include a plurality of curved surfaces disposed in the hole bezel area to surround the through hole.

In one or more embodiments, the crack detection electrode may comprise a first detection line electrically connected to the one end of the crack detection part, a second detection line electrically connected to the other end of the crack detection part, and a curved detection line connecting the first detection line and the second detection line.

In one or more embodiments, the display apparatus may further comprise a crack detection part configured to detect cracks generated in the hole bezel area of the substrate; and a connection line part electrically connecting the crack detection part and the crack stopper.

In one or more embodiments, the display apparatus may further comprise an encapsulation part that covers the light emitting device layer; and a touch sensing part disposed on the encapsulation part in the display area.

In one or more embodiments, the crack detection part may be disposed on the encapsulation part in the hole bezel area together with the touch sensing part.

In one or more embodiments, the crack detection part may include one end, the other end, and a crack detection electrode between the one end and the other end.

In one or more embodiments, the hole part may be a through hole configured to penetrate the substrate, the buffer layer, the pixel circuit layer, the overcoat layer, the light emitting device layer, the encapsulation part, and the touch sensing part.

In one or more embodiments, the crack detection electrode may include a plurality of curved surfaces disposed in the hole bezel area to surround the through hole.

In one or more embodiments, the crack detection electrode may comprise a first detection line electrically connected to the one end of the crack detection part, a second detection line electrically connected to the other end of the crack detection part, and a curved detection line connecting the first detection line and the second detection line.

In one or more embodiments, the display apparatus may further comprise an auxiliary crack detection electrode electrically connected in parallel to the crack detection electrode.

In one or more embodiments, the auxiliary crack detection electrode may comprise a first auxiliary detection line overlapping the first detection line and electrically connected to the first detection line, a second auxiliary detection line overlapping the second detection line and electrically connected to the second detection line, and an auxiliary curved detection line overlapping the curved detection line and connected between the first auxiliary detection line and the second auxiliary detection line.

In one or more embodiments, the crack stopper may include an opening portion between the one end and the other end.

In one or more embodiments, the connection line part may include a first connection line part electrically connecting the first detection line and the one end of the crack stopper, and a second connection line part electrically connecting the second detection line and the other end of the crack stopper.

In one or more embodiments, the first connection line part may include a first connection line configured to be electrically connected to the one end of the crack stopper, and a second connection line configured to electrically connect the first detection line and the first connection line.

In one or more embodiments, the second connection line part may include a third connection line configured to be electrically connected to the other end of the crack stopper, and a fourth connection line configured to electrically connect the second detection line and the third connection line.

In one or more embodiments, the display apparatus may comprise a driving integrated circuit disposed in the non-display area of the substrate and connected to the pixel circuit; a first link line electrically connected between the one end of the crack stopper and the driving integrated circuit, and a second link line electrically connected between the other end of the crack stopper and the driving integrated circuit.

In one or more embodiments, the driving integrated circuit may be configured to measure a change in resistance values between the first link line and the second link line.

In one or more embodiments, the display apparatus may comprise a driving integrated circuit disposed in the non-display area of the substrate and connected to the pixel circuit; and a stopper power line electrically connected between the first stopper pattern and the driving integrated circuit.

In one or more embodiments, the stopper power line may be electrically connected to a ground terminal or a high-potential power terminal of the driving integrated circuit.

In one or more embodiments, the display apparatus may further comprise a driving integrated circuit disposed in the non-display area of the substrate and connected to the pixel circuit; a first link line electrically connected between the first detection line and the driving integrated circuit; and a second link line electrically connected between the second detection line and the driving integrated circuit.

In one or more embodiments, the driving integrated circuit may be configured to measure a change in resistance values between the first link line and the second link line.

In one or more embodiments, the display apparatus may further comprise an edge barrier structure disposed in the non-display area of the substrate.

In one or more embodiments, the edge barrier structure may include an undercut region or an eave structure for discontinuing the continuity of the light emitting device formed in the non-display area.

In one or more embodiments, the edge barrier structure may be disposed at a non-display area of the substrate so as to surround at least two corners of the display area adjacent to the hole part among corners of the display area.

In one or more embodiments, the display apparatus may comprise a bezel crack stopper disposed along the non-display area of the substrate.

In one or more embodiments, the display apparatus may comprise an encapsulation part covers the light emitting device layer; and a touch sensing part disposed on the encapsulation part in the display area.

In one or more embodiments, the bezel crack stopper may be configured to form a bezel partition wall between the substrate and the touch sensing part.

In one or more embodiments, the display apparatus may comprise a bezel crack stopper disposed along the non-display area of the substrate.

In one or more embodiments, the display apparatus may further comprise a driving integrated circuit disposed in the non-display area of the substrate and electrically connected to each of the pixel circuit, the crack stopper, and the bezel crack stopper.

In one or more embodiments, the driving integrated circuit may be configured to measure a change in resistance values of each of the crack detection part and the bezel crack stopper.

In one or more embodiments, the display apparatus of may comprise an encapsulation part covers the light emitting device layer; and a touch sensing part disposed on the encapsulation part in the display area.

In one or more embodiments, the bezel crack stopper may be configured to form a bezel partition wall between the substrate and the touch sensing part.

In one or more embodiments, the bezel crack stopper may comprise a first metal pattern disposed between the substrate and the buffer layer, a second metal pattern disposed at the pixel insulating layer and electrically connected to the first metal pattern, and a third metal pattern disposed at the touch sensing part and electrically connected to the second metal pattern.

In one or more embodiments, the second metal pattern and the third metal pattern may form the bezel partition wall.

In one or more embodiments, the display apparatus may comprise an edge barrier structure disposed in the non-display area of the substrate.

In one or more embodiments, the edge barrier structure may include an undercut region or an eave structure for discontinuing the continuity of the light emitting device formed in the non-display area.

In one or more embodiments, the edge barrier structure may be disposed at a non-display area of the substrate so as to surround at least two corners of the display area adjacent to the hole part among corners of the display area.

The display apparatus of one or more embodiments of the disclosure further comprises a crack detection part configured to detect cracks generated in the hole bezel area of the substrate.

The display apparatus of one or more embodiments of the disclosure further comprises a crack detection part configured to detect cracks generated in the hole bezel area of the substrate, and a connection line part electrically connecting the crack detection part and the crack stopper.

The display apparatus of one or more embodiments of the disclosure further comprises an edge barrier structure disposed in the non-display area of the substrate. The edge barrier structure includes an undercut region or an eave structure for discontinuing the continuity of the light emitting device formed in the non-display area.

The display apparatus of one or more embodiments of the disclosure further comprises a bezel crack stopper disposed along the non-display area of the substrate.

The display apparatus of one or more embodiments of the disclosure further comprises an encapsulation part configured to cover the light emitting device layer, and a touch sensing part disposed on the encapsulation part in the display area. The bezel crack stopper is configured to form a bezel partition wall between the substrate and the touch sensing part.

The display apparatus of one or more embodiments of the disclosure further comprises a driving integrated circuit disposed in the non-display area of the substrate and electrically connected to each of the pixel circuit, the crack stopper, and the bezel crack stopper. The driving integrated circuit is configured to measure a change in resistance values of each of the crack detection part and the bezel crack stopper.

Details of other exemplary embodiments will be included in the detailed description of the disclosure and the accompanying drawings.

One or more embodiments of the disclosure may provide a display apparatus including a hole configured in a display area.

One or more embodiments of the disclosure may provide a display apparatus capable of blocking the propagation of cracks generated at the periphery of a hole configured in a display area and preventing brightness defects (or bright spot defects) in a bezel area of the hole.

One or more embodiments of the disclosure may provide a display apparatus capable of detecting cracks generated at the periphery of a hole configured in a display area.

One or more embodiments of the disclosure may provide a display apparatus capable of preventing moisture permeation and color abnormalities in a bezel area of a substrate.

One or more embodiments of the disclosure may provide a display apparatus capable of detecting cracks generated at the periphery of a hole formed in a display area and in a bezel area of a substrate, blocking the propagation of the cracks, preventing moisture permeation and color defects in the bezel area of the substrate, and preventing brightness defects (or bright spot defects) in the bezel area of the hole.

Other systems, methods, features and advantages will be, or will become, apparent to one with skill in the art upon examination of the following figures and detailed description. It is intended that all such additional systems, methods, features and advantages be included within this description, be within the scope of the present disclosure, and be protected by the following claims. Nothing in this section should be taken as a limitation on those claims. Further aspects and advantages are discussed below in conjunction with aspects of the disclosure.

It is to be understood that both the foregoing description and the following description of the present disclosure are exemplary and explanatory and are intended to provide further explanation of the disclosure as claimed.

### BRIEF DESCRIPTION OF THE SEVERAL VIEWS OF THE DRAWINGS

The accompanying drawings, which are included to provide a further understanding of the disclosure, are incorporated in and constitute a part of this disclosure, illustrate aspects and embodiments of the disclosure and together with the description serve to explain principles of the disclosure.
FIG. 1 is a diagram illustrating a display apparatus of a first embodiment of the disclosure.
FIG. 2 is an enlarged view of portion "A" illustrated in FIG. 1.
FIG. 3 is a cross-sectional view taken along line I-I' of FIG. 2.
FIG. 4 is an enlarged view of portion "B" illustrated in FIG. 1.
FIG. 5 is a cross-sectional view taken along line II-II' of FIG. 4.
FIG. 6 is an enlarged view of portion "C" illustrated in FIG. 5.
FIG. 7 is a diagram illustrating a display apparatus of a second embodiment of the disclosure.
FIG. 8 is a diagram illustrating a display apparatus of a third embodiment of the disclosure.
FIG. 9 is an enlarged view of portion "D" illustrated in FIG. 8.
FIG. 10 is a cross-sectional view taken along line III-III' of FIG. 9.
FIG. 11 is a diagram illustrating an equivalent circuit diagram of crack detection lines illustrated in
FIGs. 8 to 10.

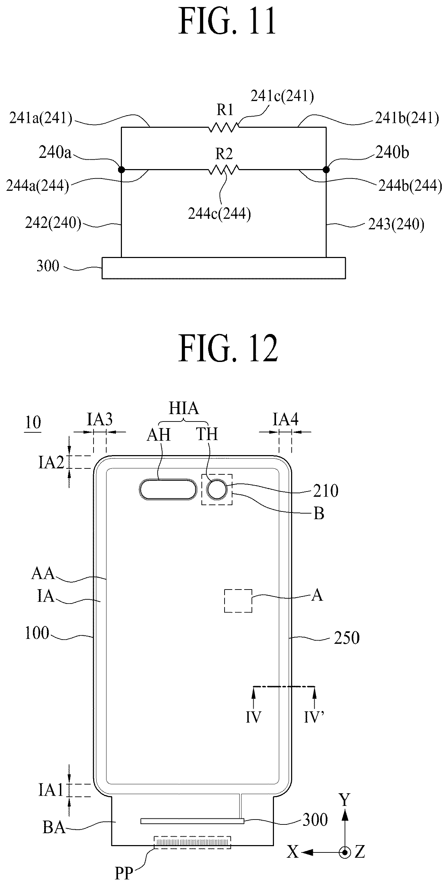

FIG. 12 is a diagram illustrating a display apparatus of a fourth embodiment of the disclosure.

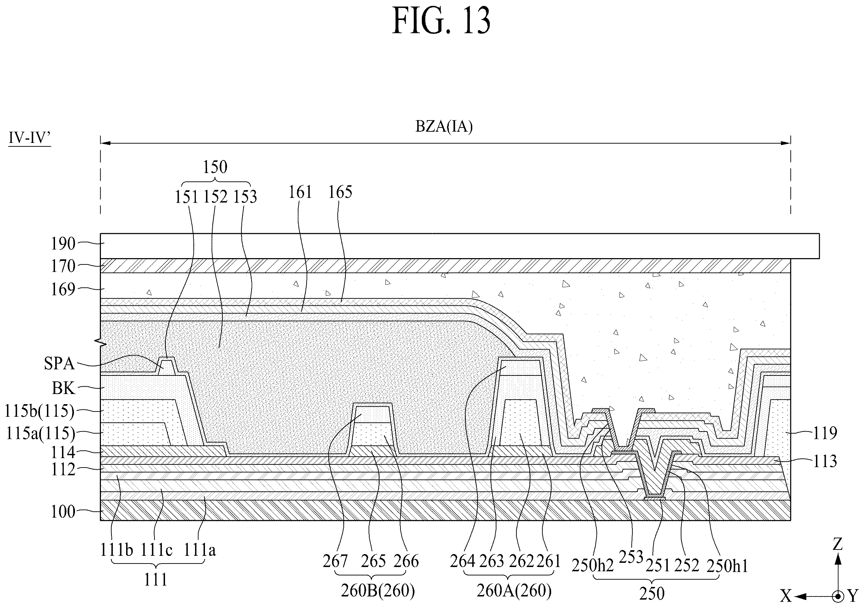

FIG. 13 is a cross-sectional view taken along line IV-IV' of FIG. 12.

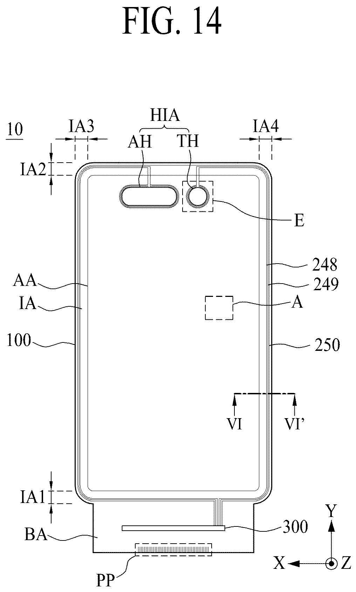

FIG. 14 is a diagram illustrating a display apparatus of a fifth embodiment of the disclosure.

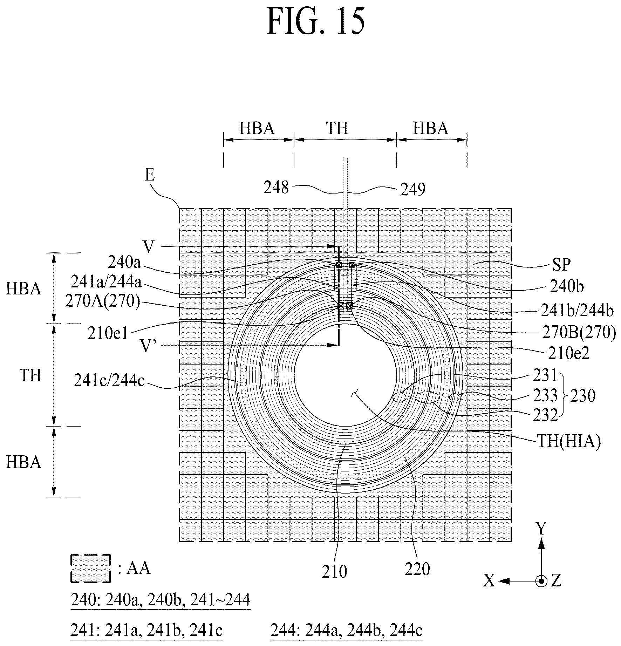

FIG. 15 is an enlarged view of portion "E" illustrated in FIG. 14.

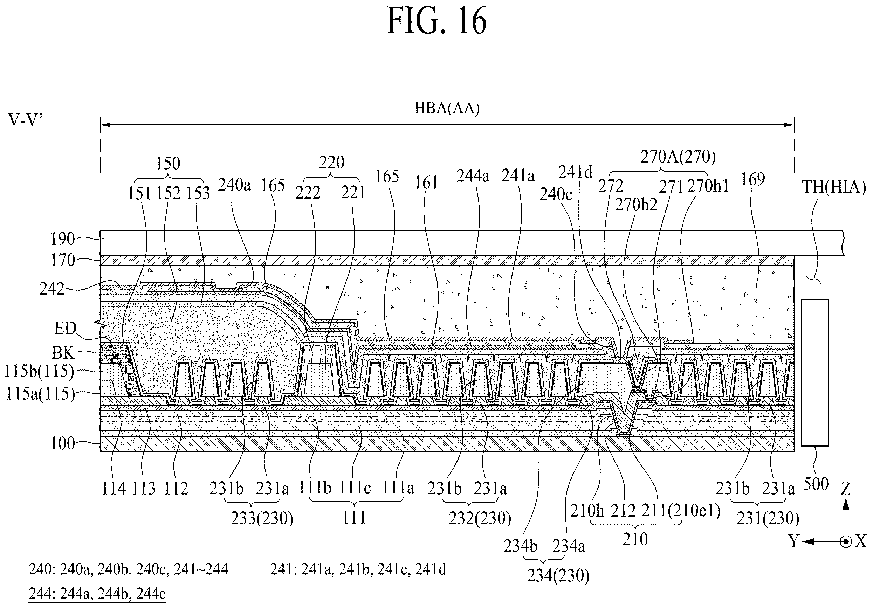

FIG. 16 is a cross-sectional view taken along line V-V' of FIG. 15.

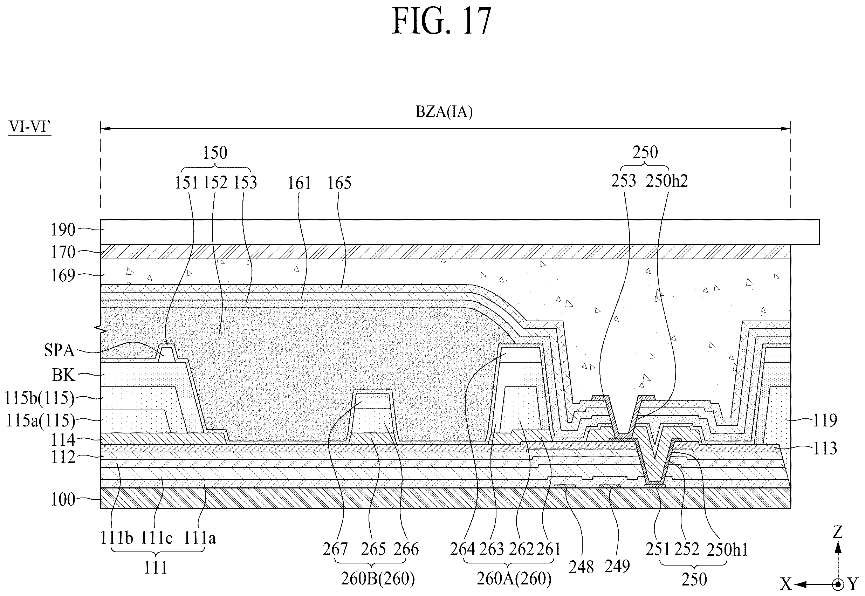

FIG. 17 is a cross-sectional view taken along line VI-VI' of FIG. 14.

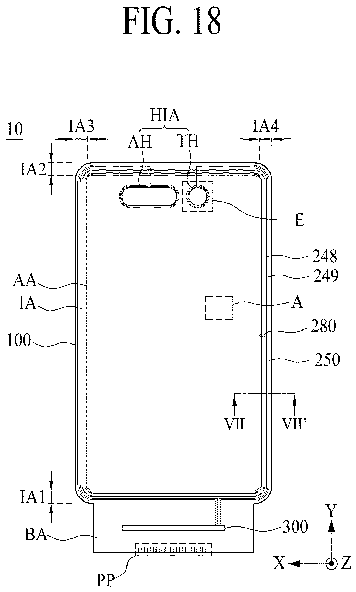

FIG. 18 is a diagram illustrating a display apparatus of a sixth embodiment of the disclosure.

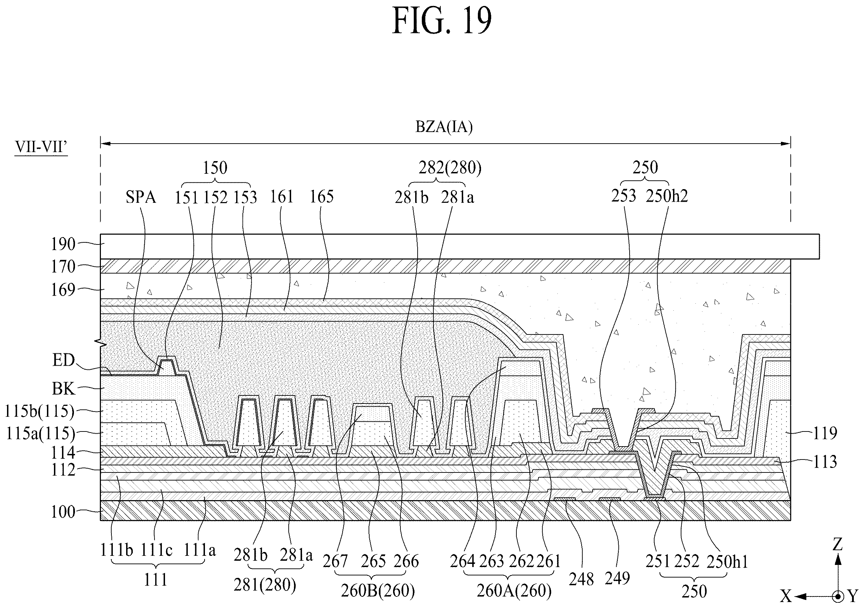

FIG. 19 is a cross-sectional view taken along line VII-VII' of FIG. 18.

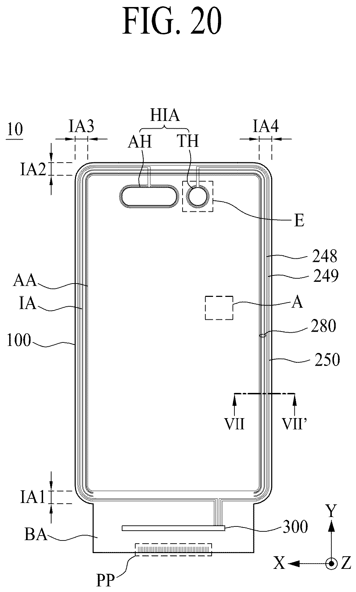

FIGs. 20 to 22 are diagrams illustrating an edge barrier structure of another embodiment of the disclosure.

Throughout the drawings and the detailed description, unless otherwise described, the same drawing reference numerals should be understood to refer to the same elements, features, and structures.

### DETAILED DESCRIPTION

Advantages and features of the present disclosure, and implementation methods thereof, are clarified through the aspects described with reference to the accompanying drawings. The present disclosure may, however, be embodied in different forms and should not be construed as limited to the example aspects set forth herein. Rather, these example aspects are examples and are provided so that this disclosure may be thorough and complete to assist those skilled in the art to understand the inventive concepts without limiting the protected scope of the present disclosure.

The shapes, sizes, dimensions (e.g., length, width, height, thickness, radius, diameter, area, etc.), ratios, angles, number of elements, and the like illustrated in the accompanying drawings for describing the embodiments of the present disclosure are merely examples, and the present disclosure is not limited thereto.

A dimension including size and a thickness of each component illustrated in the drawing are illustrated for convenience of description, and the present disclosure is not limited to the size and the thickness of the component illustrated, but it is to be noted that the relative dimensions including the relative size, location, and thickness of the components illustrated in various drawings submitted herewith are part of the present disclosure.

Like reference numerals refer to like elements throughout. In the following description, when the detailed description of the relevant known function or configuration is determined to unnecessarily obscure the important point of the present disclosure, the detailed description will be omitted.

In a situation where "comprise," "have," and "include" described in the present disclosure are used, another part may be added unless "only" is used. The terms of a singular form can include plural forms unless referred to the contrary.

In construing an element, the element is construed as including an error range although there is no explicit description.

In describing a position relationship, for example, when a position relation between two parts is described as "on," "over," "under," "next," and "adjacent to" or the like, one or more other parts may be located between the two parts unless a more limiting term, such as "immediate(ly)," "direct(ly)," or "close(ly)" is used.

For the expression that an element is "connected," "coupled," "contact," or "attach" to another element, the element may not only be directly connected, coupled, or contacted to another element, but also be indirectly connected, coupled, contacted, or attached to another element with one or more intervening elements interposed between the elements, unless otherwise specified.

To further elaborate, as used herein, the term "connected" is intended to have the broadest possible meaning. Specifically, the phrase "A is connected to B" encompasses both a direct connection-where no intervening components or elements are present-and an indirect connection, where one or more intermediate components or elements exist between A and B. In other words, "A is connected to B" includes both direct physical or electrical coupling and indirect coupling through one or more intervening components. Unless explicitly stated otherwise, these terms do not require direct physical or electrical contact. The term "coupled" and "in contact" should be interpreted in the same manner.

For the expression that an element is "contacts" or "overlaps" with another element, the element can not only directly contact, overlap, or the like with another element, but also indirectly contact or overlap with another element with one or more intervening elements disposed or interposed between the elements, unless otherwise specified.

"a first direction," "a second direction," "a third direction," "X-axis direction," "Y-axis direction," and "Z-axis direction" should not be construed by a geometric relation only of a mutual vertical relation and may have broader directionality within the range that elements of the present disclosure may act functionally.

Features of various embodiments of the present disclosure may be partially or overall coupled to or combined with each other and may be variously inter-operated with each other and driven technically as those skilled in the art can sufficiently understand. The embodiments of the present disclosure may be carried out independently from each other or may be carried out together in co-dependent relationship.

Hereinafter, example embodiments of a display apparatus according to the present disclosure will be described in detail with reference to the accompanying drawings. For convenience of description, a scale of each of elements illustrated in the accompanying drawings differs from a real scale, and thus, is not limited to a scale illustrated in the drawings.

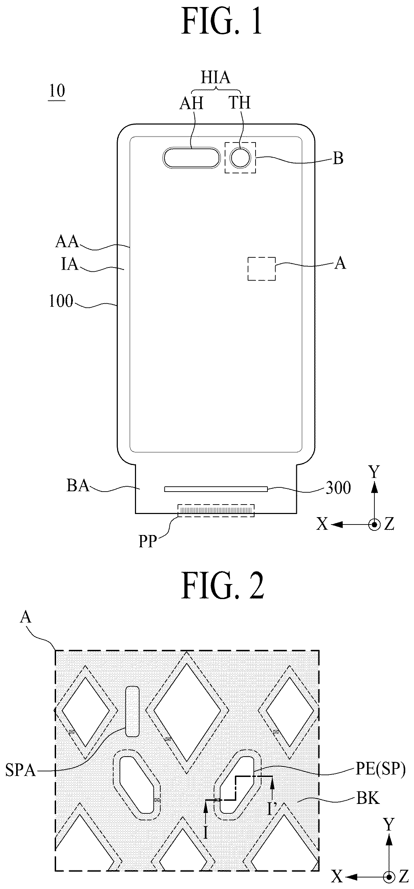

FIG. 1 is a diagram illustrating a display apparatus according to a first embodiment of the present disclosure.

Referring to FIG. 1, a display apparatus (or display panel) 10 according to a first embodiment of the present disclosure may include a display area AA and a non-display area IA defined on a substrate 100.

The display area (or an active area) AA may include a plurality of sub-pixels configured to display an image on the substrate 100. The display area AA according to an embodiment may include a plurality of red sub-pixels, a plurality of green sub-pixels, and a plurality of blue sub-pixels. Adjacent red, green, and blue sub-pixels among the plurality of sub-pixels may implement one unit pixel configured to display one color image.

The non-display area (or an inactive area) IA may be an area where an image is not displayed. The non-display area (or inactive area) IA may include an edge portion of the substrate 100 surrounding the display area AA.

The non-display area IA may be configured or structured to have a minimized width to allow expansion of the display area AA. The non-display area IA may include control lines and driving circuits for driving the plurality of sub-pixels. For example, the non-display area IA may include a gate driving circuit connected to gate lines and data link lines (or data routing lines) connected to data lines, or the like.

The display apparatus (or display panel) 10 according to the first embodiment of the present disclosure may further include a bending area BA extending from one side of the substrate 100.

The bending area BA may extend from one side of the non-display area IA. The non-display area IA may include the bending area BA. The bending area BA may be bent toward a rear surface of the display area AA with a predetermined curvature from the one side of the non-display area IA. The non-display area IA or the bending area BA may include a driving integrated circuit 300.

The driving integrated circuit 300 may be mounted on the substrate 100 in the bending area BA and may be connected to the pixel circuit. The driving integrated circuit 300 may be configured to drive or control the plurality of sub-pixels and the gate driving circuit. For example, the driving circuit 140 may be mounted on the bending area BA of the substrate 100 by a chip bonding process or a chip-on-film process.

The driving integrated circuit 300 may generate and output a data signal and a gate control signal based on image data and timing synchronization signal supplied from an external host driving circuit through a pad part PP. The data signal may be supplied to data lines of the pixel part, and the gate control signal may be supplied to the gate driving circuit.

The gate control signal may include one or more gate start signals, a plurality of gate shift clocks, and a plurality of gate driving voltages. Accordingly, the gate driving circuit may generate a gate signal (or a gate pulse) in a predetermined order in response to the gate control signal supplied from the driving integrated circuit 300 and supply the gate signal (or gate pulse) to corresponding gate line.

The driving integrated circuit 300 may generate and output various driving powers (or driving voltages) necessary for displaying an image in the pixel part based on an input power (or input voltage) supplied from the host driving circuit through the pad part PP.

The driving integrated circuit 300 may be configured to include various circuits necessary to display an image in the pixel part. For example, the driving integrated circuit 300 may include various integrated circuits and driving circuits such as a gate control signal generating circuit, a data signal generating circuit, a power generating circuit, and a clock generating circuit, or the like. For example, the driving integrated circuit 300 may be an integrated driving integrated circuit, but is not limited thereto.

The display apparatus (or display panel) 10 according to the first embodiment of the present disclosure may further include a hole part HIA disposed (or formed) within the display area AA.

The hole part HIA may be configured to vertically penetrate the display panel including the substrate 100. For example, the hole part HIA may be configured to accommodate one or more of a camera and various sensors. The hole part HIA may be a through hole, a camera hole, a sensor hole, a hollow portion, an opening hole, or a panel through hole.

The hole part HIA according to an embodiment may include one or more holes. For example, the hole part HIA may include a through hole TH.

The through hole TH may be disposed at an upper edge of the display area AA. For example, the through hole TH may accommodate a camera, but is not limited thereto. The through hole TH may have a circular shape, but is not limited thereto, and may have various shapes such as a rectangular shape or the like. For example, the through hole TH may be a camera hole, a hollow portion, an opening hole, a panel through hole, a display area hole, a main hole, or a first hole.

The hole part HIA according to an embodiment may further include an auxiliary through hole AH disposed (or configured) parallel to the through hole TH.

The auxiliary through hole AH may be disposed at the upper edge of the display area AA adjacent to the through hole TH. The auxiliary through hole AH may accommodate one or more of an infrared camera, a depth camera, a flash module, a proximity sensor, an ambient light sensor, a speaker (or receiver), a microphone, a facial recognition sensor, and a wide-angle camera. The auxiliary through hole AH may have a line shape including a curved surface, but is not limited thereto, and may have various shapes such as a rectangular shape or the like. For example, the auxiliary through hole AH may be a sensor hole, a camera/sensor hole, a second through hole, a second camera hole, a second hollow portion, a second opening hole, a second panel through hole, a second display area hole, or an auxiliary hole.

As described above, the display apparatus (or display panel) 10 according to the first embodiment of the present disclosure includes a hole part HIA disposed (or formed) within the display area AA, and thus, a width (or a bezel width) of the non-display area IA may be reduced or minimized, and a size (or area) of the display area AA may be maximized, thereby maximizing user screen immersion.

FIG. 2 is an enlarged view of portion "A" illustrated in FIG. 1. FIG. 2 illustrates an embodiment of a planar structure of the plurality of sub-pixels disposed in the display area of FIG. 1.

Referring to FIG. 2, the plurality of sub-pixels SP according to an embodiment of the present disclosure may be disposed to have a pentile type planar structure. For example, a pixel electrode PE of each of the plurality of sub-pixels SP may be disposed to have a pentile type planar structure.

An edge portion of each pixel electrode PE of the plurality of sub-pixels SP may be covered by a bank BK. The bank BK may include an opening portion corresponding (or overlapping) to a central portion of the pixel electrodes PE, thereby defining an opening area for each of the plurality of sub-pixels SP.

A spacer SPA may be disposed in a portion of a region between the plurality of sub-pixels SP. The spacer SPA may be disposed to have a predetermined density at an entire area of the display area AA. The spacer SPA may be formed (or configured) on the bank BK. The spacer SPA may be configured to support a deposition mask which is used in a deposition process for the display area AA, but is not limited thereto. For example, the spacer SPA may be omitted.

In FIG. 2, the pixel electrode PE of each of the plurality of sub-pixels SP is illustrated as having a pentile type planar structure, but is not limited thereto. For example, the pixel electrode PE of each of the plurality of sub-pixels SP may have a planar structure of an RGB stripe type or RGBW stripe type.

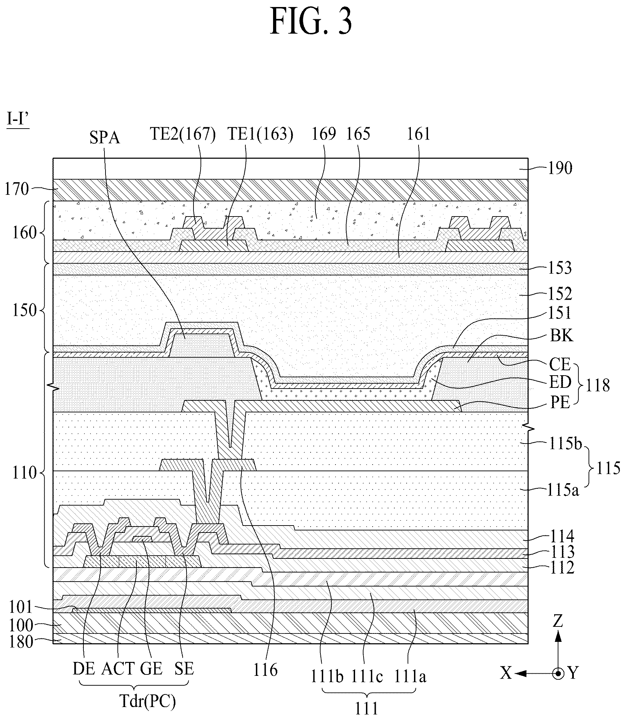

FIG. 3 is a cross-sectional view taken along line I-I' of FIG. 2. FIG. 3 is a cross-sectional view schematically illustrating one sub-pixel illustrated in FIG. 2.

Referring to FIGs. 2 and 3, the display apparatus (or display panel) according to an embodiment of the present disclosure may include a substrate 100, a pixel part 110, and an encapsulation part 150.

The substrate 100 may be made of a plastic material. For example, the substrate 100 may include a plastic material such as polyimide.

The pixel part 110 (or pixel array part) may include a buffer layer 111, a pixel circuit PC, an overcoat layer 115, and a light emitting device layer 118.

The buffer layer 111 may be disposed on the substrate 100. The buffer layer 111 may serve to prevent a material of the substrate 100 from being diffused to a transistor in performing a high-temperature processes in a manufacture process of thin film transistors, or external water or moisture from penetrating into the light emitting device layer 118.

The buffer layer 111 according to an embodiment may include a first buffer layer 111a disposed on the substrate 100, and a second buffer layer 111b stacked on the first buffer layer 111a.

The buffer layer 111 according to an embodiment may further include a third buffer layer 111c disposed (or interposed) between the first buffer layer 111a and the second buffer layer 111b. The third buffer layer 111c may be configured to block the penetration of moisture through the substrate 100.

Each of the first to third buffer layers 111a, 111b, and 111c may be made of an inorganic material. For example, one or more of the first to third buffer layers 111a, 111b, and 111c may be made of different inorganic materials, but is not limited thereto. For example, the first to third buffer layers 111a, 111b, and 111c may be made of a same inorganic material.

The pixel circuit PC may include a plurality of thin film transistors including a driving thin film transistor Tdr disposed in the sub-pixel area on the buffer layer 111.

The driving thin film transistor Tdr may include an active layer ACT, a gate electrode GE, a source electrode SE, and a drain electrode DE.

The active layer ACT may be disposed (or formed) on the substrate 100. For example, the active layer ACT may include a semiconductor material based on metal oxide such as indium-gallium-zinc-oxide (IGZO), but is not limited thereto and may include a semiconductor material based on silicon such as amorphous silicon or polycrystalline silicon or the like. For example, the active layer ACT may be formed in a pattern shape by depositing a semiconductor material on the buffer layer 111, a heat treatment process (or an annealing process) for stabilization, and a patterning process on the semiconductor material.

The active layer ACT may include a source region, a drain region, and a channel region between the source region and the drain region. The active layer ACT may be covered by a first insulating layer (or a gate insulating layer) 112.

The first insulating layer 112 may be formed in an island shape on only the channel region of the active layer ACT, or may be formed to cover an entire front surface of the buffer layer 111 including the active layer ACT. The first insulating layer 112 may be a single layer of an inorganic material, but is not limited thereto, and may be made of an organic material.

The gate electrode GE may be disposed on the first insulating layer 112 to overlap the channel region of the active layer ACT. The gate electrode GE may be formed of a gate metal material. For example, the gate electrode GE may be formed together with the gate line. For example, the gate electrode GE and the plurality of gate lines may be formed simultaneously by patterning a metal material layer.

The gate electrode GE may be covered by a second insulating layer (or an interlayer insulating layer) 113. The second insulating layer 113 may be formed on the first insulating layer 112 to cover the gate electrode GE. The second insulating layer 113 may be a single layer of an inorganic material, but is not limited thereto, and may be made of an organic material.

The source electrode SE may be disposed on the second insulating layer 113 to be electrically connected to the source region of the active layer ACT. The source electrode SE may be electrically connected to the source region of the active layer ACT through a contact hole formed in the first insulating layer 112 and the second insulating layer 113 overlapping the source region of the active layer ACT.

The drain electrode DE may be disposed on the second insulating layer 113 to be electrically connected to the drain region of the active layer ACT. The drain electrode DE may be electrically connected to the drain region of the active layer ACT through a contact hole formed in the first insulating layer 112 and the second insulating layer 113 overlapping the drain region of the active layer ACT.

The source electrode SE and the drain electrode DE may be formed of a source/drain metal material. For example, the source electrode SE and the drain electrode DE may be made of a same or different conductive materials as the gate electrode GE. The source electrode SE and the drain electrode DE may be formed together with the data line. For example, the source electrode SE, the drain electrode DE, and the plurality of data lines may be simultaneously formed by patterning a metal material layer.

The pixel circuit PC may further include at least one switching thin film transistor and at least one capacitor disposed in the sub-pixel area. The at least one switching thin film transistor may have a same structure as the driving thin film transistor Tdr, and thus a detailed description thereof is omitted. The at least one capacitor may be provided in an overlapping area between the gate electrode GE and the source electrode SE of the driving thin film transistor Tdr, which overlap each other with the second insulating layer 113 therebetween.

The driving thin film transistor Tdr or the pixel circuit PC may be covered by a passivation layer 114. The passivation layer 114 may be formed of a single or multiple layers of an inorganic material, but is not limited thereto, and may be made of an organic material. The passivation layer 114 may be a third insulating layer or a protective layer, or the passivation layer 114 may be omitted.

Additionally, the driving thin film transistor provided in the pixel circuit PC may have a characteristics that a threshold voltage is shifted by light, and to prevent this, the display panel or substrate 100 may further include a light shielding pattern 101 provided under (or below) the active layer ACT of one or more of the driving thin film transistor Tdr and the at least one switching thin film transistor.

The light shielding pattern 101 may be disposed (or interposed) between the substrate 100 and the buffer layer 111 so as to overlap the active layer ACT, but is not limited thereto. The light shielding pattern 101 may be formed (or disposed) together with a plurality of lower metal lines configured to be in direct contact with the substrate 100 to drive a plurality of sub-pixels. For example, the plurality of lower metal lines and the light shielding pattern 101 may be simultaneously formed by patterning a metal material layer.

The pixel circuit PC and the first to third insulating layers 112, 113, and 114 may constitute a pixel circuit layer. For example, the pixel circuit layer may include pixel driving lines, which comprise a plurality of gate lines and a plurality of data lines formed on the buffer layer 111, the pixel circuit PC, and the first to third insulating layers 112, 113, and 114. The first to third insulating layers 112, 113, and 114 may serve as pixel insulating layers to insulate the pixel circuit PC.

The overcoat layer 115 may be provided on the substrate 100 to cover the pixel circuit PC (or the pixel circuit layer). The overcoat layer 115 may be implemented to planarize an upper portion (or a top portion) of the pixel circuit PC or the third insulating layer 114 and to protect the pixel circuit PC.

The overcoat layer 115 according to an embodiment may include a first overcoat layer 115a, and a second overcoat layer 115b formed on the first overcoat layer 115a. The first overcoat layer 115a and the second overcoat layer 115b may have a same thickness or different thicknesses. The overcoat layer 115 (or the first and second overcoat layers 115a and 115b) may be made of an organic material. The overcoat layer 115 (or the first and second overcoat layers 115a and 115b) may be formed of an organic material such as an acrylic resin, an epoxy resin, a phenolic resin, a polyamide resin, or a polyimide resin.

The light emitting device layer 118 may be disposed (or configured) on the overcoat layer 115. The light emitting device layer 118 may include a first electrode PE, a light emitting device ED, and a second electrode CE.

The first electrode PE may be disposed in a patterned shape on the overcoat layer 115. The first electrode PE may be disposed on the second overcoat layer 115b of the overcoat layer 115. The first electrode PE may be electrically connected to the source electrode SE of the driving thin film transistor TFT through an electrode contact hole formed in the overcoat layer 115. The first electrode PE may be an anode electrode or a pixel electrode. For example, the first electrode PE may be a reflective electrode configured to reflect light.

The light emitting device ED may be disposed on the first electrode PE. The light emitting device ED may be configured to emit light in response to a current flowing from the driving thin film transistor Tdr of the pixel circuit PC to the second electrode CE. The light emitting device ED according to an embodiment may be a self-emitting layer, a point light source layer, an organic light emitting layer, a light emitting diode, a micro light emitting device, or a micro light emitting diode.

The light emitting device ED according to an embodiment of the present disclosure may include an organic emission structure which is stacked on the first electrode PE in the order or reverse order of a hole layer, a light emitting layer, and an electron layer. For example, the light emitting device ED may include a tandem structure in which a plurality of light emitting layers are stacked, and may further include a charge generating layer interposed between the plurality of light emitting layers. For example, the light emitting device ED may be implemented to generate color light corresponding to a corresponding sub-pixel. For example, the light emitting device ED of a red sub-pixel may include a red organic light emitting layer, the light emitting device ED of a green sub-pixel may include a green organic light emitting layer, and the light emitting device ED of a blue sub pixel may include a blue organic light-emitting layer. For example, in the light emitting device ED, the light emitting layers may be disposed individually, but the hole layer and the electron layer may be commonly and identically disposed in the plurality of sub-pixels as common layers.

The light emitting device ED according to another embodiment of the present disclosure may include a plurality of emission structures which are stacked on the first electrode PE in the order or reverse order of a hole layer, a light emitting layer, and an electron layer. For example, the light emitting layer of each of the plurality of emission structures may generate one or more of blue light, green light, and red light or mixed light thereof. Light emitted from the light emitting device ED may implement a color image through a color filter disposed to overlap the light emitting device layer 118. For example, the light emitting layer of each of the plurality of emission structures may generate one or more of blue light, green light, and red light or mixed light thereof, and thus, the light emitting device ED may emit white light. The white light emitted from the light emitting device ED may implement a color image through a color filter disposed to overlap the light emitting device layer 118.

The second electrode CE may be disposed on the light emitting device ED. The second electrode CE may be disposed on the light emitting device ED so as to face the first electrode PE with the light emitting device ED therebetween. The second electrode CE may be a common electrode or a cathode electrode. For example, the second electrode CE may be formed of a transparent electrode configured to transmit light.

The display apparatus (or display panel) according to an embodiment of the present disclosure may further include a bank BK and a spacer SPA.

The bank BK may be disposed to define the opening portion (or an emission area) of the sub-pixel SP and cover an edge portion of the first electrode PE. For example, the bank BK may be disposed on the overcoat layer 115 to cover only the edge portion of the first electrode PE except for a central portion of the first electrode PE. For example, the bank BK may include a mesh shape. The bank BK may be formed of an organic material or an inorganic material and may include a light-absorbing material including a black pigment.

The light emitting device ED may be disposed only in the opening portion (or emission area) of each sub-pixel SP defined by the bank BK.

The spacer SPA may be disposed on the bank BK. The spacer SPA may protrude from the bank BK or be disposed on the bank BK with a same material as the bank BK. For example, the spacer SPA may be configured to support a deposition mask for forming the light emitting device ED, but is not limited thereto. For example, the spacer SPA may be a bank protrusion.

The display apparatus (or display panel) according to an embodiment of the present disclosure may further include a connection electrode (or an intermediate electrode) 116 disposed inside the overcoat layer 115 to prevent a pattern defect (or a contact defect) of the first electrode PE caused by the distance between the first electrode PE and the source electrode SE of the driving thin film transistor TFT.

The connection electrode 116 may be configured to be electrically connected to the source electrode SE of the driving thin film transistor TFT and electrically connected to the first electrode PE. For example, the connection electrode 116 may be disposed on the first overcoat layer 115a overlapping the source electrode SE of the driving thin film transistor TFT and covered by the second overcoat layer 115b. The connection electrode 116 may be electrically connected to the source electrode SE of the driving thin film transistor TFT through an electrode contact hole provided in the first overcoat layer 115a. The first electrode PE may be electrically connected to the connection electrode 116 through an electrode contact hole provided in the second overcoat layer 115b. Accordingly, the first electrode PE may be stably connected to the source electrode SE of the driving thin film transistor TFT through the connection electrode 116. The connection electrode 116 may be formed of a same or different conductive material as the source electrode SE and the drain electrode DE of the driving thin film transistor TFT.

The encapsulation part 150 may be configured to cover or surround the pixel part 110. For example, the encapsulation part 150 may be disposed on the light emitting device layer 118 and cover or surround the light emitting device layer 118.

The encapsulation part 150 may include at least one encapsulation layer. For example, the encapsulation part 150 may include one or more inorganic material layers and one or more organic material layers which are disposed on the light emitting device layer 118. For example, the encapsulation part 150 may include a first encapsulation layer 151, a second encapsulation layer 152, and a third encapsulation layer 153.

The first encapsulation layer 151 may be disposed on the second electrode CE. The second encapsulation layer 152 may be disposed on the first encapsulation layer 151. The third encapsulation layer 153 may be disposed on the first and second encapsulation layers 151 and 152 to surround the second encapsulation layer 152. For example, the first encapsulation layer 151 may be an inorganic encapsulation layer made of an inorganic material and may be disposed at the display area and non-display area to surround the pixel part 110. The second encapsulation layer 152 may be an organic encapsulation layer made of an organic material and may be disposed on the first encapsulation layer 151 in the display area. The second encapsulation layer 152 may extend to a portion of the non-display area adjacent to the display area. The third encapsulation layer 153 may be made of an inorganic material, may be disposed in the display area to surround the second encapsulation layer 152, and may be disposed in the non-display area to be in direct contact with the first encapsulation layer 151.

The display apparatus (or display panel) according to an embodiment of the present disclosure may further include a touch sensing part 160 disposed on the display area of the substrate 100.

The touch sensing part 160 may be disposed on the encapsulation part 150. For example, the touch sensing part 160 may be disposed on the third encapsulation layer 153 of the encapsulation part 150 disposed in the display area. As on example, the touch sensing part 160 may include a touch electrode layer comprising a plurality of touch driving lines and a plurality of touch sensing lines based on a mutual capacitance scheme. As another example, the touch sensing part 160 may include a touch electrode layer comprising a plurality of touch electrodes based on a self-capacitance scheme.

The touch sensing part 160 according to an embodiment may include a touch buffer layer 161, a first touch electrode layer 163, a touch insulating layer 165, a second touch electrode layer 167, and a touch protective layer 169.

The touch buffer layer 161 may be disposed on the third encapsulation layer 153 of the encapsulation part 150. For example, the touch buffer layer 161 may be made of an inorganic material, but is not limited thereto, and may be made of an organic material.

The first touch electrode layer 163 may include a plurality of first touch electrodes TE1 disposed on the touch buffer layer 161. The plurality of first touch electrodes TE1 may be made of a transparent metal or an opaque metal. For example, the plurality of first touch electrodes TE1 may be a plurality of bridge electrodes or a plurality of bridge lines, but is not limited thereto. For example, each of the plurality of first touch electrodes TE1 may include a mesh structure made of a plurality of fine lines.

The touch insulating layer 165 may be disposed on the touch buffer layer 161 to cover the first touch electrode layer 163. The touch insulating layer 165 may be made of an inorganic material, but is not limited thereto, and may be made of an organic material.

The second touch electrode layer 167 may include a plurality of second touch electrodes TE2 disposed on the touch insulating layer 165. The plurality of second touch electrodes TE2 may be made of a transparent metal or an opaque metal. For example, the plurality of second touch electrodes TE2 may be a plurality of touch sensing electrodes or a plurality of touch driving electrodes, but is not limited thereto. For example, each of the plurality of second touch electrodes TE2 may include a mesh structure made of a plurality of fine lines.

In the second touch electrode layer 167, each of the plurality of second touch electrodes TE2 disposed adjacent to each other along a first direction X or a second direction Y may be connected to each of the plurality of first touch electrodes TE1 through via holes provided in the touch insulating layer 165. Accordingly, each of the plurality of second touch electrodes TE2 disposed adjacent to each other along the first direction X or the second direction Y may be electrically connected to each other through the plurality of first touch electrodes TE1. For example, the plurality of second touch electrodes TE2 disposed adjacent to each other along the second direction Y may be connected to each other through the plurality of first touch electrodes TE1.

The touch protective layer 169 may be disposed on the touch insulating layer 165 to cover the second touch electrode layer 167. The touch protective layer 169 may be configured to planarize an upper surface (or a top surface) of the touch sensing part 160 and protect the touch sensing part 160. The touch protective layer 169 may be formed of an organic material, but is not limited thereto.

The display apparatus (or display panel) according to an embodiment of the present disclosure may further include an optical film 170 disposed on the touch sensing part 160.

The optical film 170 may include an anti-reflective layer (or anti-reflection film) attached on the touch sensing part 160. For example, the anti-reflective layer may include a circular polarizing layer (or a circular polarizing film), but the embodiments of the present disclosure are not limited thereto.

The display apparatus (or display panel) according to an embodiment of the present disclosure may further include a back plate 180 disposed on a rear surface of the substrate 100. The back plate 180 may be configured to maintain a remaining portion of the substrate 100 in a flat state except for a bending area of the substrate 100. For example, the back plate 180 may also serve as a heat dissipation member to dissipate heat generated in the display panel.

The display apparatus (or display panel) according to an embodiment of the present disclosure may further include a cover window 190 attached to the optical film 170 by using a transparent optical adhesive. The cover window 190 may have a larger size than the display panel and may be made of a transparent material. Accordingly, the hole part HIA disposed in the display area AA may be covered by the cover window 190.

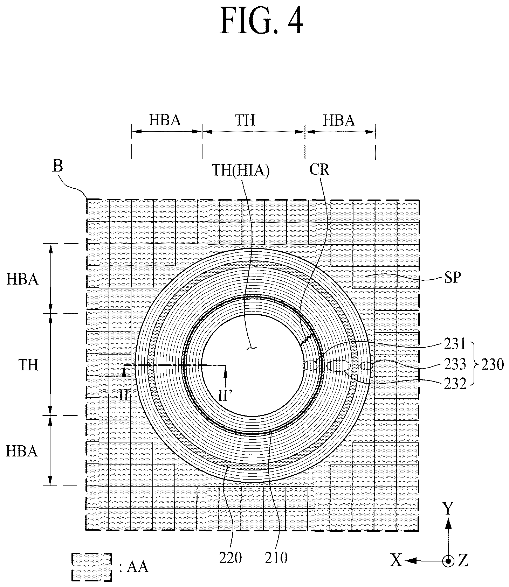

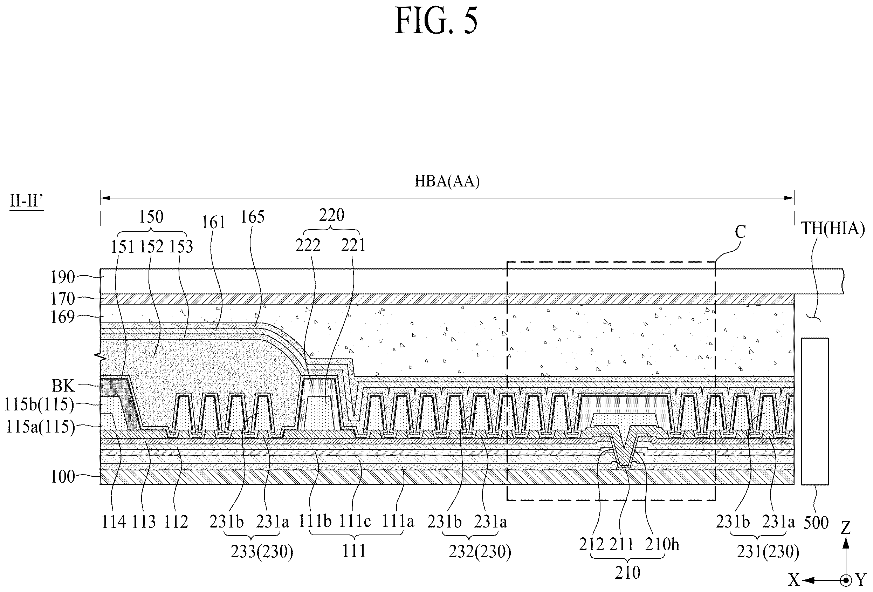

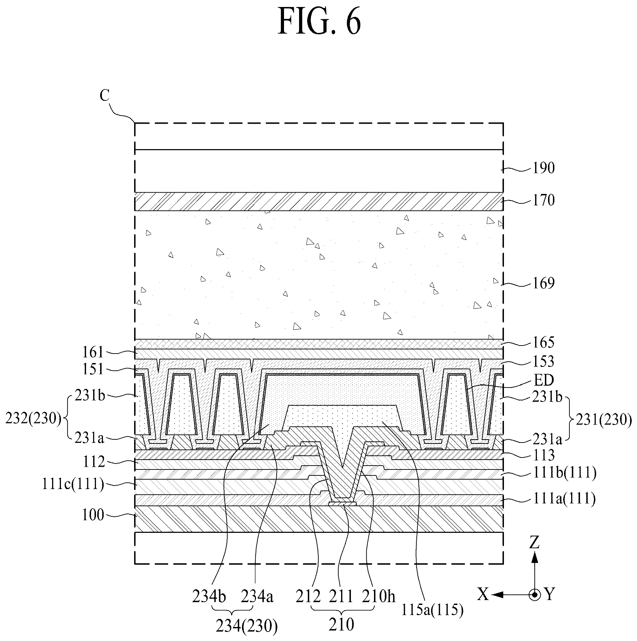

FIG. 4 is an enlarged view of portion "B" illustrated in FIG. 1, FIG. 5 is a cross-sectional view taken along line II-II' of FIG. 4, and FIG. 6 is an enlarged view of portion "C" illustrated in FIG. 5.

Referring to FIGs. 1 and 3 to 6, the hole part HIA according to an embodiment of the present disclosure may be formed to penetrate a portion of the display area AA. For example, the hole part HIA may be formed to vertically penetrate the substrate 100 and the optical film 170 as described above with reference to FIG. 3. For example, the hole part HIA may be implemented by a laser process or drilling process, but is not limited thereto. The through hole TH and auxiliary through hole AH of the hole part HIA may be configured in parallel to one side edge of the display area AA.

Each of the through hole TH and the auxiliary through hole AH of the hole part HIA may be configured to penetrate (or vertically penetrate) the substrate 100, the buffer layer 111, the pixel circuit layer, the overcoat layer 115, the light emitting device layer 118, the encapsulation part 150, the touch sensing part 160, and the optical film 170. Each of the through hole TH and the auxiliary through hole AH of the hole part HIA may be covered by the cover window 190. For example, the through hole TH may accommodate a camera 500. For example, the auxiliary through hole AH may accommodate one or more of an infrared camera, a depth camera, a flash module, a proximity sensor, an ambient light sensor, a speaker (or receiver), a microphone, a facial recognition sensor, or a wide-angle camera.

The display apparatus (or display panel) or the hole part HIA according to an embodiment of the present disclosure may further include a hole bezel area HBA.

The hole bezel area HBA may include an area between the through hole TH and the sub-pixels SP closest to the through hole TH. The hole bezel area HBA may be a non-display area within the display area AA. The hole bezel area HBA may not include any sub-pixels SP. The hole bezel area HBA may include structures configured to prevent propagation of cracks generated from the hole part HIA (or through hole TH and auxiliary through hole AH) and to block or prevent penetration of moisture or oxygen through the hole part HIA (or through hole TH and auxiliary through hole AH).

The display apparatus (or display panel) according to an embodiment of the present disclosure may further include a crack stopper 210 disposed at the hole part HIA.

The crack stopper 210 may be configured to block cracks CR generated in the hole part HIA from propagating into the hole bezel area HBA. For example, the crack stopper 210 may block cracks CR generated in the hole part HIA from propagating into one or more of inorganic layers and organic layers formed in the hole bezel area HBA.

The crack stopper 210 may be configured to prevent cracks CR generated in the hole part HIA from propagating into inside the display area AA. The crack stopper 210 may be disposed in the hole bezel area HBA. The crack stopper 210 may be disposed to have a closed-curve shape in the hole bezel area HBA.

The crack stopper 210 may block cracks CR generated around the hole part HIA from propagating (or spreading) into the display area AA by forming (or configuring) a vertical wall (or a partition wall) surrounding the hole part HIA between the substrate 100 and the overcoat layer 115.

The crack stopper 210 may be configured to surround the through hole TH of the hole part HIA. For example, the crack stopper 210 may have a closed-curve shape surrounding the through hole TH. The crack stopper 210 may block cracks CR generated around the through hole TH from propagating (or spreading) into the display area AA by forming (or configuring) a vertical wall (or partition wall) surrounding the through hole TH between the substrate 100 and the overcoat layer 115.

For example, in the process of forming the hole part HIA, the cracks CR may be generated around the hole part HIA. The cracks CR may propagate (or advance) into the display area AA over time. Accordingly, the crack stopper 210 may be configured to block cracks CR generated around the through hole TH from propagating into inside of the display area AA. For example, the crack stopper 210 may be referred to as a first crack stopper, a hole crack stopper, a crack blocking structure, a crack blocking portion, a crack blocking member, a crack propagation blocking portion, or a crack propagation blocking member, but is not limited thereto.

The crack stopper 210 according to an embodiment may include a first stopper pattern 211 and a second stopper pattern 212.

The first stopper pattern (or a first stopper line) 211 may be disposed on the substrate 100 in the hole bezel area HBA. The first stopper pattern 211 may be disposed (or interposed) between the substrate 100 and the buffer layer 111. The first stopper pattern 211 may have a shape corresponding to the through hole TH. For example, the first stopper pattern 211 may have a closed-curve shape or a ring shape (or a concentric shape) surrounding the through hole TH. The first stopper pattern 211 may be made of a metal material. For example, the first stopper pattern 211 may be formed of a same metal material as the light shielding pattern 101 and may be formed together with the light shielding pattern 101.

The second stopper pattern (or a second stopper line or a stopper metal structure) 212 may be disposed to overlap at least a portion of the first stopper pattern 211 and may be configured to be connected to the first stopper pattern 211. The second stopper pattern 212 may be configured to penetrate the buffer layer 111 and the pixel insulating layers 112 and 113 to be electrically connected to the first stopper pattern 211.

The second stopper pattern 212 may be disposed on the second insulating layer 113 to be connected to the first stopper pattern 211. The second stopper pattern 212 may be connected or electrically connected to the first stopper pattern 211 through a via hole 210h penetrating the buffer layer 111 and the first insulating layer 112 which are disposed to be cover the first stopper pattern 211. The second stopper pattern 212 may have a shape corresponding to the through hole TH and the first stopper pattern 211. For example, the second stopper pattern 212 may have a closed-curve shape or a ring shape (or concentric shape) surrounding the through hole TH. The second stopper pattern 212 may be made of a metal material. For example, the second stopper pattern 212 may be formed of a same metal material as the source electrode of the driving thin film transistor and may be formed together with the source electrode of the driving thin film transistor.

The first stopper pattern 211 and the second stopper pattern 212 may block cracks CR generated around the through hole TH from propagating (or spreading) into the display area AA by forming (or configuring) the vertical wall (or partition wall) surrounding the through hole TH between the substrate 100 and the third insulating layer 114 in the hole bezel area HBA adjacent to the through hole TH of the hole part HIA. For example, the cracks CR generated in the forming process of the through hole TH may propagate into the display area AA through thin film layers between the substrate 100 and the third insulating layer 114, and the propagation of the cracks CR may be blocked by the crack stopper 210 so that the cracks CR no longer propagate into the display area AA.

According to an embodiment of the present disclosure, friction charges (or static charges) generated on a surface of the cover window 190 may penetrate into the hole part HIA, and due to the friction charges, undesired light emission from sub-pixels SP disposed around the hole part HIA causes a bright phenomenon (or a bright spot defect) to occur around the hole part HIA. For example, a threshold voltage of the thin film transistor included in the sub-pixels SP around the hole part HIA may shift in the positive direction due to the friction charges, thereby generating leakage current due to the threshold voltage shift of the thin film transistor, and the leakage current may cause the light emitting device to emit light, and thus, the bright phenomenon may occur around the hole part HIA.

According to an embodiment of the present disclosure, since the crack stopper 210 is made of a metal material while surrounding the through hole TH of the hole part HIA, and may block the friction charges penetrating into the hole part HIA from further penetrating into the sub-pixels SP around the hole part HIA. For example, the crack stopper 210 may prevent negative friction charges generated on the surface of the cover window 190 from being accumulated under the display area AA. Accordingly, the crack stopper 210 may further prevent the bright phenomenon (or bright spot defect) occurring around the through hole TH of the hole part HIA due to the friction charges generated on the surface of the cover window 190.

The crack stopper 210 described above with reference to FIGs. 4 to 6 may be similarly disposed (or configured) around the auxiliary through hole AH of the hole part HIA, and thus, redundant description thereof is omitted.

The display apparatus (or display panel) or the hole bezel area HBA according to an embodiment of the present disclosure may further include a dam structure 220 and a barrier structure 230.

The dam structure 220 may be configured to prevent the second encapsulation layer 152 of the encapsulation part 150 disposed in the display area AA from overflowing into the hole part HIA. For example, the dam structure 220 may be a first dam structure or a hole-surrounding dam.

The dam structure 220 may be disposed (or configured) to surround the hole part HIA. The dam structure 220 may be disposed (or configured) on the third insulating layer 114. For example, the dam structure 220 may have a closed-curve shape or a ring shape (or a concentric shape) surrounding the through hole TH.

The dam structure 220 according to an embodiment may include a lower dam 221 disposed on the third insulating layer 114 and an upper dam 222 disposed on the lower dam 221.

The lower dam 221 may be made of a same material as the overcoat layer 115. The lower dam 221 may be a portion of the overcoat layer 115 formed in the display area AA (or hole bezel area HBA) that is not removed. For example, the lower dam 221 may have a same height (or thickness) as the overcoat layer 115 including the first overcoat layer 115a and the second overcoat layer 115b, but is not limited thereto.

The upper dam 222 according to an embodiment may be formed on the third insulating layer 114 to surround the lower dam 221. The upper dam 222 according to another embodiment may be stacked on an upper surface of the lower dam 221. The upper dam 222 may be made of a same material as the bank BK and may have a same height (or thickness) as the bank BK, but is not limited thereto.

The dam structure 220 may be surrounded or covered by the first encapsulation layer 151 of the encapsulation part 150.

The flow (or spreading) of the second encapsulation layer 152 of the encapsulation part 150 from the display area AA toward the hole part HIA may be blocked by the dam structure 220 or the upper dam 222 of the dam structure 220. Accordingly, the second encapsulation layer 152 may not be disposed between the dam structure 220 and the through hole TH.

The dam structure 220 described above with reference to FIGs. 4 to 6 may be similarly disposed (or configured) around the auxiliary through hole AH of the hole part HIA, and thus, redundant description thereof is omitted.

The barrier structure 230 may be configured to block moisture or oxygen penetrating through the hole part HIA into inside of the display area AA. For example, the light emitting device ED formed (or deposited) in the display area AA may also be formed (or deposited) in the hole bezel area HBA. Since the light emitting device ED formed in the hole bezel area HBA is made of an organic material with highly reactivity to moisture and/or oxygen and high permeability to moisture and/or oxygen, moisture and/or oxygen penetrating into the hole part HIA may pass through the light emitting device ED formed in the hole bezel area HBA and may penetrate into the light emitting device ED disposed in the display area AA. Accordingly, the barrier structure 230 may be configured to disconnect (or separate) the light emitting device ED (or the continuity of the light emitting device ED) formed in the hole bezel area HBA. For example, the barrier structure 230 may be a hole barrier structure, a disconnection structure, a separation structure, an undercut structure, or an eave structure.

The barrier structure 230 according to an embodiment may include one or more first barrier structures 231.

The one or more first barrier structures 231 may have a shape corresponding to the through hole TH. The one or more first barrier structures 231 may be disposed (or configured) in an area between the through hole TH and the crack stopper 210 to surround the through hole TH. For example, the one or more first barrier structures 231 may have a closed-curve shape or a ring shape (or concentric shape) surrounding the through hole TH. For example, the barrier structure 230 according to an embodiment may include three or more first barrier structures 231.

The one or more first barrier structures 231 may include a lower structure 231a and an upper structure 231b.

The lower structure 231a may be formed (or implemented) by patterning the third insulating layer 114. For example, the lower structure 231a may be formed to have a trapezoidal cross-sectional shape having a top surface and a bottom surface wider than the top surface.

The upper structure 231b may be stacked on the lower structure 231a. For example, the upper structure 231b may be formed to have a trapezoidal cross-sectional shape having a top surface and a bottom surface wider than the top surface. The bottom surface of the upper structure 231b may be in direct contact with the top surface of the lower structure 231a.

The upper structure 231b may be made of a same material as the overcoat layer 115. The upper structure 231b may be a portion of the overcoat layer 115 formed in the display area AA (or hole bezel area HBA) that is not removed. For example, the upper structure 231b may have a same height (or thickness) as the overcoat layer 115 including the first overcoat layer 115a and the second overcoat layer 115b, but is not limited thereto. For example, the upper structure 231b may have a same height (or thickness) as the first overcoat layer 115a.

Since the bottom surface of the upper structure 231b is wider than the top surface of the lower structure 231a, the upper structure 231b may have an eave structure with respect to the lower structure 231a, and the lower structure 231a may have an undercut region with respect to the upper structure 231b. Accordingly, the one or more first barrier structures 231 including the lower structure 231a and the upper structure 231b may include the eave structure and/or the undercut region.

Since the light emitting device ED formed (or deposited) on the one or more first barrier structures 231 has directivity due to the deposition method, the light emitting device ED may be partially disconnected (or separated) by the eave structure or undercut region of the one or more first barrier structures 231, and thus, the continuity of the light emitting device ED may be disconnected (or separated) by the one or more first barrier structures 231. Accordingly, the one or more first barrier structures 231 may block moisture and/or oxygen that penetrates into the hole part HIA and further penetrates into the light emitting device ED disposed in the display area AA through the light emitting device ED formed in the hole bezel area HBA, thereby protecting the light emitting device ED from moisture and/or oxygen penetrating into the hole part HIA.

The barrier structure 230 according to an embodiment may further include one or more second barrier structures 232.

The one or more second barrier structures 232 may have a shape corresponding to the through hole TH. The one or more second barrier structures 232 may be disposed (or configured) in an area between the dam structure 220 and the crack stopper 210 to surround the through hole TH. For example, the one or more second barrier structures 232 may have a closed-curve shape or a ring shape (or a concentric shape) surrounding the crack stopper 210. For example, the barrier structure 230 according to an embodiment may include five or more second barrier structures 232.

The one or more second barrier structures 232 may include a lower structure 231a and an upper structure 231b. Except that the lower structure 231a and the upper structure 231b of the one or more second barrier structures 232 are disposed (or configured) in the area between the dam structure 220 and the crack stopper 210, lower structure 231a and the upper structure 231b of the one or more second barrier structures 232 may be the same as each of the lower structure 231a and the upper structure 231b of the one or more first barrier structures 231, and thus, like reference numerals refer to like elements and redundant description thereof is omitted.

The barrier structure 230 according to an embodiment may further include one or more third barrier structures 233.

The one or more third barrier structures 233 may have a shape corresponding to the through hole TH. The one or more third barrier structures 233 may be disposed (or configured) in an area between the sub-pixels SP and the dam structure 220 to surround the through hole TH. For example, the one or more third barrier structures 233 may have a closed-curve shape or a ring shape (or a concentric shape) surrounding the dam structure 220. For example, the barrier structure 230 according to an embodiment may include three or more third barrier structures 233.

The one or more third barrier structures 233 may include a lower structure 231a and an upper structure 231b. Except that the lower structure 231a and the upper structure 231b of the one or more third barrier structures 233 are disposed (or configured) in the area between the sub-pixels SP and the dam structure 220, lower structure 231a and the upper structure 231b of the one or more third barrier structures 233 may be a same as each of the lower structure 231a and the upper structure 231b of the one or more first barrier structures 231, and thus, like reference numerals refer to like elements and redundant description thereof is omitted.

The barrier structure 230 according to an embodiment may further include a fourth barrier structure 234.

The fourth barrier structure 234 may be disposed (or configured) on the crack stopper 210. For example, the fourth barrier structure 234 may have a same closed-curve shape or ring shape (or a concentric shape) as the crack stopper 210.

The fourth barrier structure 234 may include a lower structure 234a and an upper structure 234b.

The lower structure 234a may be formed (or implemented) by patterning the third insulating layer 114 that covers the second stopper pattern 212 of the crack stopper 210. A portion of an upper surface of the lower structure 234a may be covered by a portion of the first overcoat layer 115a.

The upper structure 234b may be disposed (or configured) on the lower structure 234a to surround a portion of the first overcoat layer 115a disposed on the lower structure 234a. The upper structure 234b may cover the portion of the first overcoat layer 115a and may be in direct contact with an upper edge of the lower structure 234a. The upper structure 234b may be formed (or implemented) to have an eave structure with respect to the lower structure 234a through patterning of the bank BK. Accordingly, the upper structure 234b may have the eave structure with respect to the lower structure 234a, and the lower structure 234a may have an undercut region with respect to the upper structure 234b.

The light emitting device ED formed (or deposited) on the fourth barrier structure 234 may be further disconnected (or separated) by the eave structure or undercut region of the fourth barrier structure 234, and thus, the continuity of the light emitting device ED may be additionally disconnected (or separated) by the fourth barrier structure 234.

The one or more first to third barrier structures 231, 232, and 233 and the fourth barrier structure 234 of the barrier structure 230 described above with reference to FIGs. 4 to 6 may be similarly disposed (or configured) around the auxiliary through hole AH of the hole part HIA, and thus, redundant description thereof is omitted.

As described above, the display apparatus (or display panel) according to the first embodiment of the present disclosure includes the crack stopper 210, and thus, the propagation of cracks CR generated around the through holes TH and AH configured disposed in the display area AA may be blocked, and the brightness defects (or bright spot defects) in the hole bezel area HBA may be prevented. Furthermore, the display apparatus (or display panel) according to the first embodiment of the present disclosure further includes the barrier structure 230 surrounding the through holes TH and AH, thereby blocking moisture and/or oxygen that penetrates into the hole part HIA, passes through the light emitting device ED formed in the hole bezel area HBA, and reaches the light emitting device ED disposed in the display area AA, thereby protecting the light emitting device ED from moisture and/or oxygen.

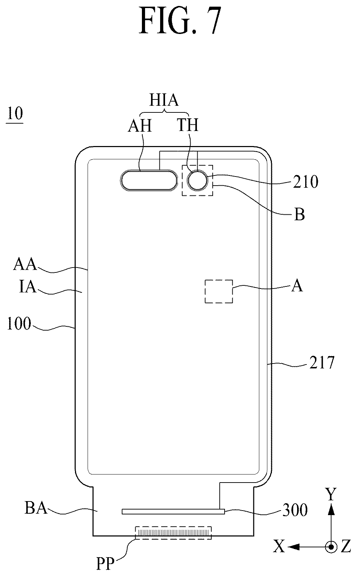

FIG. 7 is a view illustrating a display apparatus according to a second embodiment of the present disclosure. FIG. 7 illustrates an embodiment where a stopper power line is additionally configured at the display apparatus according to the first embodiment of the present disclosure described above with reference to FIGs. 1 to 6. In the following description, therefore, only additionally provided stopper power line will be described in detail, the other elements are referred to by the same reference numerals as FIGs. 1 to 6, and thus, redundant descriptions are omitted or briefly described. Therefore, descriptions above with reference to FIGs. 1 to 6 may be included in descriptions of FIG. 7.

Referring to FIG. 7, the display apparatus 10 (or display panel) according to the second embodiment of the present disclosure may include all configurations of the display apparatus 10 according to the first embodiment of the present disclosure. Therefore, the descriptions above with reference to FIGs. 1 to 6 may be included in descriptions of FIG. 7.

The display apparatus (or display panel) 10 according to the second embodiment of the present disclosure may further include a stopper power line 217.

The stopper power line 217 may be configured to be electrically connected between the crack stopper 210 and the driving integrated circuit 300. The stopper power line 217 may be disposed along the non-display area IA of the substrate 100 to be electrically connected to the crack stopper 210 formed (or disposed) in the hole part HIA. The stopper power line 217 may be disposed along the non-display area IA of the substrate 100 to be electrically connected between the crack stopper 210 and the driving integrated circuit 300.

A first side of the stopper power line 217 may be connected to the crack stopper 210 formed (or disposed) in the through hole TH of the hole part HIA. For example, the first side of the stopper power line 217 may be electrically connected to any one of the first stopper pattern 211 and the second stopper pattern 212 of the crack stopper 210. For example, the first side of the stopper power line 217 may be disposed in a same layer as the light shielding pattern 101 and may be electrically connected to the first stopper pattern 211 of the crack stopper 210.

The first side of the stopper power line 217 may be additionally connected to the crack stopper 210 formed (or disposed) in the auxiliary through hole AH of the hole part HIA. Accordingly, the first side of the stopper power line 217 may be commonly connected to the crack stoppers 210 formed (or disposed) in each of the through hole TH and the auxiliary through hole AH of the hole part HIA.

A second side of the stopper power line 217 may be configured to be electrically connected to an output terminal (or an output channel) of the driving integrated circuit 300.

The second side of the stopper power line 217 according to an embodiment may be electrically connected to a ground (or GND) terminal among output terminals of the driving integrated circuit 300. Accordingly, the negative friction charges generated on the surface of the cover window 190 may be discharged to the ground (or GND) terminal through the crack stopper 210 and the stopper power line 217, thereby preventing the bright phenomenon (or bright spot defect) generated around the through holes TH and AH of the hole part HIA due to the friction charges generated on the surface of the cover window 190.

The second side of the stopper power line 217 according to another embodiment may be electrically connected to a high-potential power terminal among the output terminals of the driving integrated circuit 300. Accordingly, a positive voltage having the opposite polarity to the negative friction charges generated on the surface of the cover window 190 may be applied to the crack stopper 210 through the stopper power line 217, the negative friction charge generated on the surface of the cover window 190 is prevented from accumulating in the metal layer under the display area AA, and thus, the bright phenomenon (or bright spot defect) generated around the through holes TH and AH of the hole part HIA may be prevented.

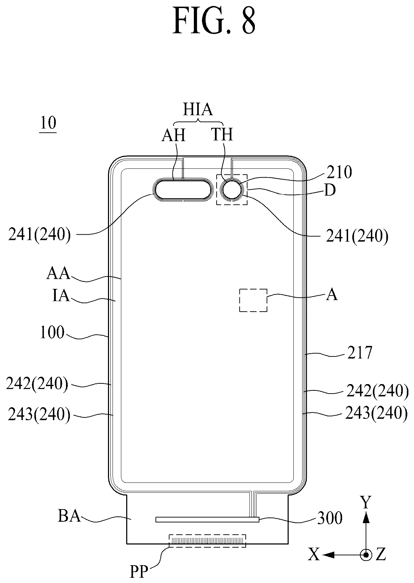

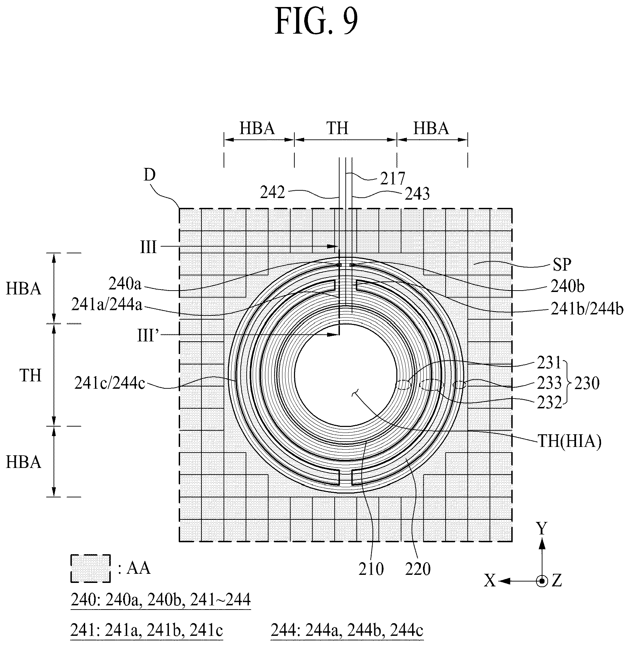

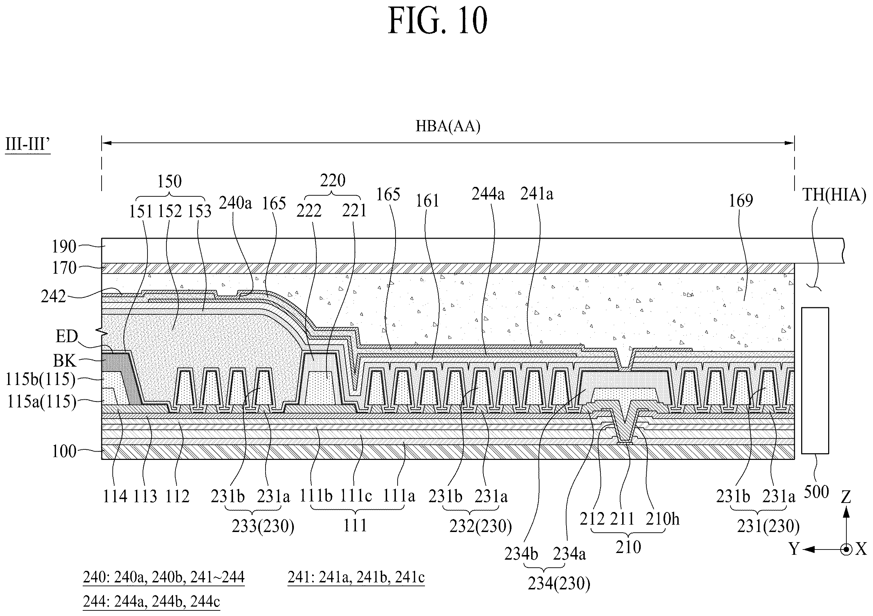

FIG. 8 is a diagram illustrating a display apparatus according to a third embodiment of the present disclosure, FIG. 9 is an enlarged view of portion "D" illustrated in FIG. 8, FIG. 10 is a cross-sectional view taken along line III-III' of FIG. 9, and FIG. 11 is a diagram illustrating an equivalent circuit diagram of crack detection lines illustrated in FIGs. 8 to 10. FIGs. 8 to 11 illustrate an embodiment where a crack detection part is additionally configured at the display apparatus according to the first embodiment of the present disclosure described above with reference to FIGs. 1 to 6. In the following description, therefore, only additionally provided crack detection part will be described in detail, the other elements are referred to by the same reference numerals as FIGs. 1 to 6, and thus, redundant descriptions are omitted or briefly described. Therefore, descriptions above with reference to FIGs. 1 to 6 may be included in descriptions of FIGs. 8 to 11.

Referring to FIGs. 8 to 11, the display apparatus 10 (or display panel) according to the third embodiment of the present disclosure may include all configurations of the display apparatus 10 according to the first embodiment or the second embodiment of the present disclosure. Therefore, the descriptions above with reference to FIGs. 1 to 7 may be included in descriptions of FIGs. 8 to 11.

The display apparatus (or display panel) 10 according to the third embodiment of the present disclosure may further include a crack detection part 240.

The crack detection part 240 may be disposed (or configured) to detect cracks occurring (or generating) around the hole part HIA. The crack detection part 240 may be disposed in the hole bezel area HBA surrounding the hole part HIA and disposed (or configured) to detect cracks occurring (or generating) in the hole bezel area HBA. The crack detection part 240 may be disposed in the hole bezel area HBA and configured to be electrically connected to the driving integrated circuit 300. For example, the crack detection part 240 may be a hole crack detection part or a first crack detection part.

The crack detection part 240 may be disposed (or configured) in the hole bezel area HBA to surround the through hole TH of the hole part HIA and may be electrically connected to the driving integrated circuit 300. For example, the crack detection part 240 may be disposed (or configured) on the encapsulation part 150 of the hole bezel area HBA surrounding the through hole TH of the hole part HIA and electrically connected to the driving integrated circuit 300. For example, the crack detection part 240 may be configured together with the touch sensing part 160 on the encapsulation part 150 of the hole bezel area HBA.

The crack detection part 240 may include one end, the other end, and a crack detection electrode 241 between the one end and the other end.

The one end and the other end of the crack detection part 240 may be disposed in parallel to each other.

The crack detection electrode 241 may be disposed (or configured) on the encapsulation part 150 (or touch insulating layer 165) so as to surround the through hole TH of the hole part HIA in the hole bezel area HBA. The crack detection electrode 241 may be disposed (or configured) to detect cracks generating in an uppermost layer of inorganic layers and organic layers which are disposed in the hole bezel area HBA. For example, the crack detection electrode 241 may be disposed (or configured) to detect cracks generating in the touch insulating layer 165 which is disposed the uppermost layer of inorganic layers and organic layers disposed in the hole bezel area HBA. For example, the crack detection electrode 241 may be made of a same metal material as the second touch electrode layer 167 illustrated in FIG. 3 and may be formed together with the second touch electrode layer 167. For example, the crack detection electrode 241 may be referred to as a crack detection sensor, a crack detection electrode sensor, a first crack detection electrode, an upper crack detection electrode, or an external crack detection electrode.

The crack detection electrode 241 may be configured to include a plurality of curved portions disposed in the hole bezel area HBA so as to surround the through hole TH of the hole part HIA. The crack detection electrode 241 according to an embodiment may include a first detection line 241a, a second detection line 241b, and a curved detection line 241c.

The first detection line 241a may be disposed (or configured) on the touch insulating layer 165 and may extend from one side edge of the display area AA toward the through hole TH of the hole part HIA. For example, the first detection line 241a may extend, from one side of the hole bezel area HBA, past the one side edge of the display area AA and the dam structure 220, onto the crack stopper 210. For example, the first detection line 241a may have a linear shape parallel to the second direction Y (or Y-axis direction), but is not limited thereto. The first detection line 241a may be one end of the crack detection part 240 or may be electrically connected to the one end of the crack detection part 240.

The second detection line 241b may be disposed (or configured) on the touch insulating layer 165 in parallel with and spaced apart from the first detection line 241a and may extend from one side edge of the display area AA toward the through hole TH of the hole part HIA. For example, the second detection line 241b may extend, from the other side of the hole bezel area HBA, past the one side edge of the display area AA and the dam structure 220, onto the crack stopper 210. For example, the second detection line 241b may have a linear shape parallel to the second direction Y (or Y-axis direction), but is not limited thereto. The second detection line 241b may be the other end of the crack detection part 240 or may be electrically connected to the other end of the crack detection part 240.

The curved detection line 241c may be disposed (or configured) on the touch insulating layer 165 in the hole bezel area HBA so as to surround the through hole TH of the hole part HIA and may be electrically connected to the first detection line 241a and the second detection line 241b.

One end of the curved detection line 241c may be connected to or branched from the first detection line 241a at the one side of the hole bezel area HBA. The other end of the curved detection line 241c may be connected to or branched from the second detection line 241b at the other side of the hole bezel area HBA.

An intermediate portion between the one end and the other end of the curved detection line 241c may be disposed to have one or more curved shapes in the hole bezel area HBA so as to surround the through hole TH of the hole part HIA. For example, the intermediate portion between the one end and the other end of the curved detection line 241c may have a zigzag shape at the one side of the hole bezel area HBA and a zigzag shape at the other side of the hole bezel area HBA. For example, the curved detection line 241c may include a first curved line between the one end and the intermediate portion and a second curved line between the first curved line and the other end thereof.

The first curved line of the curved detection line 241c may have a semicircular zigzag shape (or a maze shape) at the one side of the hole bezel area HBA. The second curved line of the curved detection line 241c may be connected to an end of the first curved line and have a semicircular zigzag shape (or a maze shape) at the other side of the hole bezel area HBA. For example, the first curved line and the second curved line may have a symmetrical structure with respect to a center (or a center point) of the hole part HIA, but are not limited thereto.

The crack detection part 240 may further include an auxiliary crack detection electrode 244.

The auxiliary crack detection electrode 244 may be disposed (or configured) on the encapsulation part 150 (or touch buffer layer 161) so as to surround the through hole TH of the hole part HIA in the hole bezel area HBA. The auxiliary crack detection electrode 244 may be disposed (or configured) to detect cracks generating in one or more of inorganic and organic layers which are disposed between the substrate 100 and the touch buffer layer 161. The auxiliary crack detection electrode 244 may be formed of a same metal material as the first touch electrode layer 163 illustrated in FIG. 3 and may be formed together with the first touch electrode layer 163. For example, the auxiliary crack detection electrode 244 may be referred to as a second crack detection electrode, a lower crack detection electrode, or an internal crack detection electrode.

The auxiliary crack detection electrode 244 according to an embodiment may include a first auxiliary detection line 244a, a second auxiliary detection line 244b, and an auxiliary curved detection line 244c.

The first auxiliary detection line 244a may extend from the one side edge of the display area AA toward the through hole TH of the hole part HIA. For example, the first auxiliary detection line 244a may extend, from the one side of the hole bezel area HBA, past the one side edge of the display area AA and the dam structure 220, onto the crack stopper 210. For example, the first auxiliary detection line 244a may have a linear shape parallel to the second direction Y (or Y-axis direction), but is not limited thereto. For example, the first auxiliary detection line 244a may overlap or may be disposed below the first detection line 241a. For example, the first auxiliary detection line 244a may overlap the first detection line 241a with the touch insulating layer 165 therebetween.

The second auxiliary detection line 244b may extend from the one side edge of the display area AA toward the through hole TH of the hole part HIA. For example, the second auxiliary detection line 244b may extend, from the other side of the hole bezel area HBA, past the one side edge of the display area AA and the dam structure 220, onto the crack stopper 210. For example, the second auxiliary detection line 244b may have a linear shape parallel to the second direction Y

(or Y-axis direction), but is not limited thereto. For example, the second auxiliary detection line 244b may overlap or may be disposed below the second detection line 241b. For example, the second auxiliary detection line 244b may overlap the second detection line 241b with the touch insulating layer 165 therebetween.

The auxiliary curved detection line 244c may be disposed (or configured) on the touch buffer layer 161 in the hole bezel area HBA so as to surround the through hole TH of the hole part HIA and may be electrically connected to the first auxiliary detection line 244a and the second auxiliary detection line 244b.

One end of the auxiliary curved detection line 244c may be connected to or branched from the first auxiliary detection line 244a at the one side of the hole bezel area HBA. The other end of the auxiliary curved detection line 244c may be connected to or branched from the second auxiliary detection line 244b at the other side of the hole bezel area HBA.

An intermediate portion between the one end and the other end of the auxiliary curved detection line 244c may be disposed to have one or more curved shapes in the hole bezel area HBA so as to surround the through hole TH of the hole part HIA. For example, the intermediate portion between the one end and the other end of the auxiliary curved detection line 244c may have a zigzag shape at the one side of the hole bezel area HBA and a zigzag shape at the other side of the hole bezel area HBA. For example, the auxiliary curved detection line 244c may include a first auxiliary curved line between the one end and the intermediate portion and a second auxiliary curved line between the first auxiliary curved line and the other end thereof.

The first auxiliary curved line of the auxiliary curved detection line 244c may have a semicircular zigzag shape (or a maze shape) at the one side of the hole bezel area HBA. The second auxiliary curved line of the auxiliary curved detection line 244c may be connected to an end of the first auxiliary curved line and have a semicircular zigzag shape (or a maze shape) at the other side of the hole bezel area HBA. For example, the first auxiliary curved line and the second auxiliary curved line may have a symmetrical structure with respect to the center (or center point) of the hole part HIA, but are not limited thereto.

The auxiliary curved detection line 244c may overlap or may be disposed below the curved detection line 241c. For example, the auxiliary curved detection line 244c may overlap the curved detection line 241c with the touch insulating layer 165 therebetween.

According to an embodiment, the auxiliary crack detection electrode 244 may be configured to be electrically connected in parallel with the crack detection electrode 241 as illustrated in FIG. 11. For example, the crack detection electrode 241 and the auxiliary crack detection electrode 244 may function as resistors R1 and R2 electrically connected in parallel for crack detection.

The first detection line 241a of the crack detection electrode 241 may be electrically connected to the first auxiliary detection line 244a of the auxiliary crack detection electrode 244. For example, the other side edge portion (or a second portion) of the first detection line 241a may be electrically connected to the first auxiliary detection line 244a. For example, the other side edge portion (or a second portion) of the first detection line 241a may be electrically connected to the first auxiliary detection line 244a through a first via hole 240a provided in the touch insulating layer 165.

The second detection line 241b of the crack detection electrode 241 may be electrically connected to the second auxiliary detection line 244b of the auxiliary crack detection electrode 244. For example, the other side edge portion (or a second portion) of the second detection line 241b may be electrically connected to the second auxiliary detection line 244b. For example, the other side edge portion of the second detection line 241b may be electrically connected to the second auxiliary detection line 244b through a second via hole 240b provided in the touch insulating layer 165.

Accordingly, the crack detection electrode 241 connected between the first detection line 241a and the second detection line 241b may be electrically connected in parallel to the auxiliary crack detection electrode 244 through the first via hole 240a and the second via hole 240b.

The crack detection electrode 241 and the auxiliary crack detection electrode 244 of the crack detection part 240 described above with reference to FIGs. 8 to 11 may be disposed (or configured) around the auxiliary through hole AH of the hole part HIA in a same manner, and thus, redundant descriptions are omitted.

The display apparatus (or display panel) 10 according to the third embodiment of the present disclosure may further include a first link line 242 and a second link line 243 electrically connected to the crack detection part 240.

The first link line 242 may be configured to be electrically connected between one end of the crack detection part 240 and the driving integrated circuit 300. For example, the first link line 242 may be disposed (or configured) on the touch insulating layer 165 and may be configured to be electrically connected from the first detection line 241a of the crack detection part 240 to the driving integrated circuit 300 via the non-display area IA of the substrate 100.

The second link line 243 may be configured to be electrically connected between the other end of the crack detection part 240 and the driving integrated circuit 300. For example, the second link line 243 may be disposed (or configured) on the touch insulating layer 165 and may be configured to be electrically connected from the second detection line 241b of the crack detection part 240 to the driving integrated circuit 300 via the non-display area IA of the substrate 100. The first link line 242 and the second link line 243 may be disposed in parallel to each other in the non-display area IA of the substrate 100.

The first link line 242 and the second link line 243 may be made of a same metal material as any one of the first touch electrode layer 163 and the second touch electrode layer 167 illustrated in FIG. 3 and may be formed together with any one of the first touch electrode layer 163 and the second touch electrode layer 167.

The driving integrated circuit 300, which is electrically connected to the crack detection part 240 disposed around the through hole TH of the hole part HIA, may measure resistance values of the crack detection electrode 241 and the auxiliary crack detection electrode 244 disposed around the through hole TH, and may be configured to detect a crack or moisture penetration based on a change in the measured resistance values, but is not limited thereto. For example, the driving integrated circuit 300 may continuously apply or periodically apply a preset voltage (or a crack detection voltage) to the first link line 242 and the second link line 243, and may detect the crack or the moisture penetration generating around the through hole TH based on a change in the applied voltage due to the change in resistance values of each of the first link line 242 and the second link line 243 caused by the crack or the moisture. Likewise, the driving integrated circuit 300 may detect the crack or the moisture penetration generating around the auxiliary through hole AH based on a change in the applied voltage due to a change in resistance values of the first link line 242 and the second link line 243 of the crack detection part 240 disposed around the auxiliary through hole AH of the hole part HIA.

FIG. 12 is a diagram illustrating a display apparatus according to a fourth embodiment of the present disclosure, and FIG. 13 is a cross-sectional view taken along line IV-IV' of FIG. 12. The portion "A" illustrated in FIG. 12 is illustrated in FIG. 2, and the portion "B" illustrated in FIG. 12 is illustrated in FIG. 4.

Referring to FIGs. 12 and 13, the display apparatus 10 (or display panel) according to the fourth embodiment of the present disclosure may include all configurations of the display apparatus 10 according to one or more of the first to third embodiments of the present disclosure. Therefore, the descriptions above with reference to FIGs. 1 to 11 may be included in descriptions of FIGs. 12 and 13.

The display apparatus (or display panel) 10 of the fourth embodiment of the disclosure may further include a bezel crack stopper 250.

The bezel crack stopper 250 may be configured to block (or prevent) propagation (or spreading) of cracks generating in the non-display area IA of the substrate 100 and to detect cracks generating in the non-display area IA of the substrate 100.

The bezel crack stopper 250 may be disposed in the non-display area IA (or a bezel area BZA) of the substrate 100 and may be configured to block (or prevent) propagation (or spreading) of cracks generated from a side surface (or sidewall) of the substrate 100 or generating in the non-display area IA of the substrate 100. In addition, the bezel crack stopper 250 may be configured to detect cracks generated from the side surface of the substrate 100 or generating in the non-display area IA of the substrate 100. For example, the bezel crack stopper 250 may serve both as a structure for blocking (or preventing) propagation of cracks and as a sensor for detecting cracks. Accordingly, the bezel crack stopper 250 may be a bezel crack stopper, a bezel crack blocking part, a bezel crack blocking structure, an edge crack stopper, an edge crack blocking part, or an edge crack detection part.

The non-display area IA of the substrate 100 may include a first non-display area IA1 between the display area AA and a bending area BA, a second non-display area IA2 parallel to the first non-display area IA1 with the display area AA therebetween, a third non-display area IA3 adjacent to a first long side of the substrate 100, and a fourth non-display area IA4 adjacent to a second long side of the substrate 100. For example, the second to fourth non-display areas IA2, IA3, and IA4 may be the bezel area BZA.

The bezel crack stopper 250 may be disposed (or configured) along the non-display area IA disposed at an edge portion of the substrate 100. For example, the bezel crack stopper 250 may be disposed at the second to fourth non-display areas IA2, IA3, and IA4 of the non-display area IA, and may be electrically connected to the driving integrated circuit 300 in the first non-display area IA1. Accordingly, the remaining portion of the display area AA except for one side of the display area AA adjacent to the first non-display area IA1 of the non-display area IA may be surrounded by the bezel crack stopper 250.

The bezel crack stopper 250 may be configured to form (or configure) a vertical wall (or a partition wall) between the substrate 100 and the touch sensing part 160 in order to block (or prevent) propagation of cracks. For example, the bezel crack stopper 250 may be configured to form (or configure) a bezel partition wall (or bezel vertical wall) between the substrate 100 and an upper surface of the touch insulation layer 165 in the bezel area BZA of the substrate 100.

The bezel crack stopper 250 according to an embodiment may include a first metal pattern 251, a second metal pattern 252, and a third metal pattern 253.

The first metal pattern 251 may be disposed on the second to fourth non-display areas IA2, IA3, and IA4 of the non-display area IA of the substrate 100. The first metal pattern 251 may be disposed (or interposed) between the substrate 100 and the buffer layer 111. The first metal pattern 251 may have a line shape continuously disposed along the second to fourth non-display areas IA2, IA3, and IA4 of the non-display area IA. For example, the first metal pattern 251 may be made of a same metal material as the light shielding pattern 101, and may be formed together with the light shielding pattern 101. For example, the first metal pattern 251 may be a detection line, a stopper line, or a detection/stopper line. For example, a first side (or one end) and a second side (or the other end) of the first metal pattern 251 may be electrically connected to the driving integrated circuit 300 disposed in the bending area BA of the substrate 100. For example, sine the first metal pattern 251 is in direct contact with the substrate 100, and thus, may block the propagation of cracks generating on the substrate 100 corresponding to the bezel area BZA.

The second metal pattern (or the first stopper structure) 252 may be disposed so as to overlap at least a portion of the first metal pattern 251 and may be connected to the first metal pattern 251. The second metal pattern 252 may be disposed on the pixel insulating layer and may be electrically connected to the at least a portion of the first metal pattern 251. For example, the second metal pattern 252 may be disposed on the second insulating layer 113 and may be electrically connected to the at least a portion of the first metal pattern 251. The second metal pattern 252 may have a line shape corresponding to the first metal pattern 251. The second metal pattern 252 may be connected or electrically connected to the first metal pattern 251 through a first via hole 250h1 that sequentially penetrates the buffer layer 111, the first insulating layer 112, and the second insulating layer 113 covering the first metal pattern 251. For example, the second metal pattern 252 may be made of a same metal material as a source electrode of the driving thin film transistor, and may be formed together with the source electrode of the driving thin film transistor.

The second metal pattern 252 may block propagation (or spreading) of a crack generating from the side surface of the substrate 100 or generating in the bezel area BZA of the substrate 100 into the display area AA by forming (or configuring) the bezel partition wall between the substrate 100 and the third insulating layer 114 in the bezel area BZA of the substrate 100. For example, the second metal pattern 252 may block propagation of cracks generating in one or more of the buffer layer 111, the first insulating layer 112, and the third insulating layer 114.

The third metal pattern (or the second stopper structure) 253 may be disposed so as to overlap at least a portion of the second metal pattern 252 and may be connected to the second metal pattern 252. The third metal pattern 253 may be disposed on the touch sensing part 160 and may be electrically connected to the at least a portion of the second metal pattern 252. For example, the third metal pattern 253 may be disposed on the touch insulating layer 165 and may be electrically connected to the second metal pattern 252. The third metal pattern 253 may have a shape corresponding to the second metal pattern 252. The third metal pattern 253 may be connected or electrically connected to the second metal pattern 252 through a second via hole 250h2 that sequentially penetrates the third insulating layer 114, the first encapsulation layer 151, the third encapsulation layer 153, the touch buffer layer 161, and the touch insulating layer 165 covering the second metal pattern 252. For example, the third metal pattern 253 may be made of a same metal material as the second touch electrode layer 167 shown in FIG. 3, and may be formed together with the second touch electrode layer 167.

The third metal pattern 253 may detect cracks generated from the side surface of the substrate 100 or generated in the bezel area BZA of the substrate 100, and may block propagation (or spreading) of cracks into the display area AA, by forming (or configuring) the bezel partition wall between the second insulating layer 113 and the upper surface of the touch insulating layer 165 in the bezel area BZA of the substrate 100. For example, the third metal pattern 253 may detect cracks generating in one or more of the third insulating layer 114, the touch buffer layer 161, and the touch insulating layer 165, and may block propagation of cracks.

One end and the other end of the bezel crack stopper 250 may be disposed in the first non-display area IA1 of the non-display area IA and may be electrically connected to the driving integrated circuit 300. For example, the one end and the other end of the first metal pattern 251 of the bezel crack stopper 250 may be disposed in the first non-display area IA1.

The driving integrated circuit 300 may be electrically connected to one end and the other end of the first metal pattern 251 of the bezel crack stopper 250. The driving integrated circuit 300 may measure resistance values of the bezel crack stopper 250 and may be configured to detect cracks or moisture penetration based on changes in the measured resistance values, but is not limited thereto. For example, the driving integrated circuit 300 may continuously or periodically apply a preset voltage (or crack detection voltage) to the first metal pattern 251 through the one end and the other end of the first metal pattern 251, and may detect cracks or moisture penetration generating in the bezel area BZA based on changes in the applied voltage due to resistance changes of the first metal pattern 251 caused by the cracks or the moisture.

The display apparatus (or display panel) 10 according to the fourth embodiment of the present disclosure may further include a bezel dam structure 260.

The bezel dam structure 260 may be configured to block overflow of the second encapsulation layer 152 of the encapsulation part 150 disposed in the display area AA to an outside of the side surface of the substrate 100. For example, the bezel dam structure 260 may be a second dam structure or an edge dam structure.

The bezel dam structure 260 may be disposed (or configured) along the non-display area IA so as to surround the display area AA of the substrate 100. The bezel dam structure 260 may be disposed (or configured) on the second insulating layer 113. For example, the bezel dam structure 260 may have a closed-curve shape or a frame shape surrounding the display area AA of the substrate 100. The bezel dam structure 260 may be disposed (or configured) to have a preset height on the second insulating layer 113. The bezel dam structure 260 may be formed by patterning one or more inorganic films and one or more organic films which is disposed on the second insulating layer 113.

The bezel dam structure 260 may be surrounded or covered by the first encapsulation layer 151 of the encapsulation part 150.

The flow (or spread) of the second encapsulation layer 152 of the encapsulation part 150 flowing or spreading from the display area AA toward the side surface (or sidewall) of the substrate 100 may be blocked by the bezel dam structure 260. Accordingly, the second encapsulation layer 152 may not be disposed in a region between the bezel dam structure 260 and the side surface (or sidewall) of the substrate 100.

The bezel dam structure 260 according to an embodiment may include a first bezel dam structure 260A and a second bezel dam structure 260B. For example, the first bezel dam structure 260A may be a bezel dam structure, and the second bezel dam structure 260B may be a middle dam structure or a bezel middle dam structure.

The first bezel dam structure 260A may include first to fourth dams 261, 262, 263, and 264.

The first dam 261 may be disposed on the second insulating layer 113 adjacent to the bezel crack stopper 250. For example, the first dam 261 may be made of a same material as the third insulating layer 114. For example, the first dam 261 may be formed (or configured) by patterning the third insulating layer 114 which is disposed on the second insulating layer 113.

The second dam 262 may be disposed (or stacked) on the first dam 261. For example, the second dam 262 may be made of a same material as the overcoat layer 115. For example, the second dam 262 may be formed (or configured) by patterning the overcoat layer 115 which is disposed on the third insulating layer 114.

The third dam 263 may be disposed (or stacked) on the second dam 262. The third dam 263 may be disposed to surround the second dam 262. The third dam 263 may surround the second dam 262 and may contact an edge portion of the first dam 261. For example, the third dam 263 may be made of a same material as the bank BK. For example, the third dam 263 may be formed (or configured) by patterning the bank BK.

The fourth dam 264 may be disposed (or stacked) on the third dam 263. For example, the fourth dam 264 may be made of a same material as the spacer SPA. For example, the fourth dam 264 may be formed (or configured) by patterning the spacer SPA. For example, the fourth dam 264 may be configured to support a deposition mask used in a deposition process for the display area AA together with the spacer SPA.

The flow (or spread) of the second encapsulation layer 152 flowing or spreading from the display area AA toward the bezel area BZA may be blocked by the fourth dam 264 of the first bezel dam structure 260A.

The second bezel dam structure 260B may serve to primarily block the flow (or spread) of the second encapsulation layer 152 flowing or spreading from the display area AA toward the bezel area BZA.

The second bezel dam structure 260B may include a first to a third dam 265, 266, and 267.

The first dam 265 may be disposed on the second insulating layer 113 which is disposed between the first bezel dam structure 260A and the display area AA. The first dam 265 of the second bezel dam structure 260B may be formed together with the first dam 261 of the first bezel dam structure 260A.

The second dam 266 may be disposed (or stacked) on the first dam 265. The second dam 266 of the second bezel dam structure 260B may be formed together with the second dam 262 of the first bezel dam structure 260A.

The third dam 267 may be disposed (or stacked) on the second dam 266. The third dam 267 of the second bezel dam structure 260B may be formed together with the fourth dam 264 of the first bezel dam structure 260A.

The display apparatus (or display panel) 10 according to a fourth embodiment of the present disclosure may further include a clad layer 119.

The clad layer 119 may be disposed (or configured) along an end portion of the substrate 100. The clad layer 119 may be configured to prevent or protect the end portion and corner portions of the substrate 100 from being damaged during a scribing process (or trimming process) of the substrate 100, but is not limited thereto.

The clad layer 119 may be configured to cover end portions of each of the buffer layer 111, the first insulating layer 112, and the second insulating layer 113 which are disposed at the end portion of the substrate 100. The clad layer 119 may be made of an organic material, but is not limited thereto. For example, the clad layer 119 may be formed together with the overcoat layer 115. The clad layer 119 may be covered by a plurality of organic films and a plurality of inorganic films. For example, the clad layer 119 may be covered by a material layer of the bank BK, a material layer of the spacer SPA, the first encapsulation layer 151, the third encapsulation layer 153, the touch buffer layer 161, and the touch insulating layer 165. For example, a portion of the clad layer 119 may be cut (or severed) by the scribing process (or trimming process).

As described above, since the display apparatus (or display panel) according to the fourth embodiment of the present disclosure includes the bezel crack stopper 250, so that cracks generating in the bezel area BZA of the substrate 100 may be detected through the bezel crack stopper 250, and propagation of cracks generating in the bezel area BZA of the substrate 100 may be blocked by the bezel crack stopper 250.

FIG. 14 is a diagram illustrating a display apparatus according to a fifth embodiment of the present disclosure, FIG. 15 is an enlarged view of portion "E" illustrated in FIG. 14, FIG. 16 is a cross-sectional view taken along line V-V' of FIG. 15, and FIG. 17 is a cross-sectional view taken along line VI-VI' of FIG. 14. The portion "A" illustrated in FIG. 14 is illustrated in FIG. 2. FIGs. 14 to 17 illustrate an embodiment where a connection line part is additionally configured at the display apparatus according to the fourth embodiment of the present disclosure described above with reference to FIGs. 1 to 11 and where the crack stopper and the crack detection part are modified. In the following description, therefore, only additionally provided connection line part and modified the crack stopper and the crack detection part will be described in detail, the other elements are referred to by the same reference numerals as FIGs. 1 to 11, and thus, redundant descriptions are omitted or briefly described. Therefore, descriptions above with reference to FIGs. 1 to 11 may be included in descriptions of FIGs. 14 to 17.

Referring to FIGs. 14 to 17, a display apparatus 10 (or display panel) according to a fifth embodiment of the present disclosure may include all of the configurations of the display apparatus 10 according to the fourth embodiment of the present disclosure. Therefore, the description above with reference to FIGs. 12 and 13 may be included in the description of FIGs. 14 to 17.

In the display apparatus (or display panel) 10 of the fifth embodiment of the disclosure, the crack stopper 210 may be configured to have a circular shape having an opening portion between one end 210e1 and the other end 210e2. For example, the opening portion of the crack stopper 210 may be additionally configured to the crack stopper 210 described above with reference to FIGs. 4 to 6. Accordingly, the crack stopper 210 may include one end 210e1 and the other end 210e2 by the opening portion.

The crack stopper 210 may include a first stopper pattern 211 and a second stopper pattern 212. Except for having the opening portion, each of the first stopper pattern 211 and the second stopper pattern 212 are substantially a same as each of the first stopper pattern 211 and the second stopper pattern 212 described with reference to FIGs. 4 to 6, and thus, redundant descriptions are omitted.

The crack detection electrode 241 and the auxiliary crack detection electrode 244 of the crack detection part 240 described above with reference to FIGs. 15 and 16 may be disposed (or configured) around the auxiliary through hole AH of the hole part HIA in a same manner, and thus, redundant descriptions are omitted.

In the display apparatus (or display panel) 10 according to the fifth embodiment of the present disclosure, the crack detection part 240 may be disposed (or configured) to detect cracks generating around the hole part HIA. The crack detection part 240 may be disposed in the hole bezel area HBA adjacent to the hole part HIA and may be disposed (or configured) to detect cracks generating in the hole bezel area HBA.

The crack detection part 240 may include a crack detection electrode 241 disposed in the hole bezel area HBA.

The crack detection electrode 241 may be disposed (or configured) on the encapsulation part 150 (or touch insulating layer 165) so as to surround the through hole TH of the hole part HIA in the hole bezel area HBA. The crack detection electrode 241 may be disposed (or configured) to detect cracks generating in the uppermost layer of inorganic layers and organic layers which are disposed in the hole bezel area HBA. For example, the crack detection electrode 241 is substantially a same as the crack detection electrode 241 described above with reference to FIGs. 8 to 10, and thus, redundant description thereof is omitted.

The crack detection electrode 241 according to an embodiment may include a first detection line 241a, a second detection line 241b, and a curved detection line 241c. The first detection line 241a, the second detection line 241b, and the curved detection line 241c are substantially a same as the first detection line 241a, the second detection line 241b, and the curved detection line 241c described above with reference to FIGs. 8 to 10, and thus, redundant descriptions are omitted.

The crack detection part 240 may further include an auxiliary crack detection electrode 244.

The auxiliary crack detection electrode 244 may be disposed (or configured) on the encapsulation part 150 (or touch buffer layer 161) so as to surround the through hole TH of the hole part HIA in the hole bezel area HBA. The auxiliary crack detection electrode 244 may be disposed (or configured) to detect cracks generating in one or more of inorganic layers and organic layers which are disposed between substrate 100 and touch buffer layer 161. For example, the auxiliary crack detection electrode 244 is substantially a same as the auxiliary crack detection electrode 244 described above with reference to FIGs. 8 to 10, and thus, redundant description thereof is omitted.

The auxiliary crack detection electrode 244 may include a first auxiliary detection line 244a, a second auxiliary detection line 244b, and an auxiliary curved detection line 244c. The first auxiliary detection line 244a, the second auxiliary detection line 244b, and the auxiliary curved detection line 244c are substantially a same as the first auxiliary detection line 244a, the second auxiliary detection line 244b, and the auxiliary curved detection line 244c described with reference to FIGs. 8 to 10, and thus, redundant descriptions are omitted.

The crack detection electrode 241 and the auxiliary crack detection electrode 244 of the crack detection part 240 described above with reference to FIGs. 15 and 16 may be identically disposed (or configured) around the auxiliary through hole AH of the hole part HIA, and therefore, redundant description thereof is omitted.

The display apparatus (or display panel) 10 according to the fifth embodiment of the present disclosure may further include a connection line part 270.

The connection line part 270 may be configured to electrically connect the crack stopper 210 and the crack detection part 240. The connection line part 270 may be disposed (or interposed) between the crack stopper 210 and the crack detection part 240, and may be configured to electrically connect the crack detection part 240 to the crack stopper 210. The connection line part 270 may be configured to electrically connect the one end 210e1 of the crack stopper 210 and one end of the crack detection part 240, and to electrically connect the other end 210e2 of the crack stopper 210 and the other end of the crack detection part 240. The connection line part 270 may be configured to electrically connect the one end 210e1 of the crack stopper 210 and the first detection line 241a of the crack detection part 240 (or the crack detection electrode 241), and to electrically connect the other end 210e2 of the crack stopper 210 and the second detection line 241b of the crack detection part 240 (or the crack detection electrode 241). Accordingly, the display apparatus (or display panel) 10 according to the fifth embodiment of the present disclosure includes the crack stopper 210 and the crack detection part 240 electrically connected by the connection line part 270, and thus, may detect cracks in all layers between the substrate 100 and the crack detection part 240.

The connection line part 270 according to an embodiment may include a first connection line part 270A and a second connection line part 270B.

The first connection line part 270A may be configured to electrically connect the one end 210e1 of the crack stopper 210 and the one end of the crack detection part 240. The first connection line part 270A may be configured to electrically connect the one end 210e1 of the crack stopper 210 and the first detection line 241a of the crack detection part 240 (or the crack detection electrode 241). Accordingly, the first detection line 241a of the crack detection part 240 (or the crack detection electrode 241) may be electrically connected to the one end 210e1 of the crack stopper 210 through the first connection line part 270A.

The first connection line part 270A may include a first connection line 271 and a second connection line 272.

The first connection line 271 may be configured to be electrically connected to the one end 210e1 of the crack stopper 210. The first connection line 271 may be disposed on the third insulating layer 114 covering the one end 210e1 of the crack stopper 210 so as to overlap at least a portion of the one end 210e1 of the crack stopper 210, and may be configured to be electrically connected to the one end 210e1 of the crack stopper 210. The first connection line 271 may be electrically connected to the second stopper pattern 212 of the crack stopper 210 through a first contact hole 270h1 formed in the third insulating layer 114. For example, the first connection line 271 may be made of a same metal material as the connection electrode 116 illustrated in FIG. 3 and may be formed together with the connection electrode 116.

The first connection line 271 may be covered by the overcoat layer 115. The first connection line 271 may be covered by the fourth barrier structure 234 of the barrier structure 230. For example, the first connection line 271 may be covered by the upper structure 234b of the fourth barrier structure 234. The first connection line 271 may be disposed inside the fourth barrier structure 234 of the barrier structure 230. For example, the first connection line 271 may be disposed (or interposed) between the lower structure 234a and the upper structure 234b of the fourth barrier structure 234.

The second connection line 272 may be disposed on the overcoat layer 115 so as to overlap at least a portion of the first connection line 271, and may be configured to be electrically connected to the first connection line 271. The second connection line 272 may be disposed on the fourth barrier structure 234 of the barrier structure 230 so as to overlap the at least a portion of the first connection line 271. For example, the second connection line 272 may be disposed on the upper structure 234b of the fourth barrier structure 234 so as to overlap the at least a portion of the first connection line 271.

The second connection line 272 may be electrically connected to the first connection line 271 through a second contact hole 270h2 formed in the overcoat layer 115 (or the upper structure 234b of the fourth barrier structure 234). For example, the second connection line 272 may be made of a same metal material as the pixel electrode PE illustrated in FIG. 3 and may be formed together with the pixel electrode PE.

The second connection line 272 may be covered by the first encapsulation layer 151, the third encapsulation layer 153, the touch buffer layer 161, and the touch insulating layer 165. The second connection line 272 may be electrically connected to the first detection line 241a of the crack detection part 240 (or the crack detection electrode 241).

In the crack detection part 240, the first detection line 241a of the crack detection electrode 241 may further include a line contact part 241d electrically connected to the first connection line part 270A of the connection line part 270.

The line contact part 241d of the first detection line 241a may be electrically connected to the second connection line 272 of the first connection line part 270A through a contact hole 240c passing through the first encapsulation layer 151, the third encapsulation layer 153, the touch buffer layer 161, and the touch insulating layer 165 covering the first connection line part 270A. Accordingly, the first detection line 241a of the crack detection electrode 241 of the crack detection part 240 may be electrically connected to the first stopper pattern 211 through the line contact part 241d, the second connection line 272, the first connection line 271, and the second stopper pattern 212. In addition, the first auxiliary detection line 244a of the auxiliary crack detection electrode 244 overlapping the crack detection electrode 241 of the crack detection part 240 is electrically connected to the first detection line 241a through the first via hole 240a, so that the first auxiliary detection line 244a may be electrically connected to the first stopper pattern 211 through the line contact part 241d of the first detection line 241a, the second connection line 272, the first connection line 271, and the second stopper pattern 212.

The second connection line part 270B may be configured to electrically connect the other end 210e2 of the crack stopper 210 and the other end of the crack detection part 240. The second connection line part 270B may be configured to electrically connect the other end 210e2 of the crack stopper 210 and the second detection line 241b of the crack detection part 240 (or the crack detection electrode 241). Accordingly, the second detection line 241b of the crack detection part 240 (or the crack detection electrode 241) may be electrically connected to the other end 210e2 of the crack stopper 210 through the second connection line part 270B.

The second connection line part 270B may include a first connection line (or third connection line) and a second connection line (or fourth connection line). Each of the first connection line and the second connection line of the second connection line part 270B is substantially a same as the first connection line 271 and the second connection line 272 of the first connection line part 270A illustrated in FIG. 16, and thus, the same reference numerals are applied, and redundant descriptions are omitted or briefly described.

The first connection line 271 may be configured to electrically connect the other end 210e2 of the crack stopper 210 and the second detection line 241b of the crack detection part 240. The first connection line 271 may be disposed on the third insulating layer 114 covering the other end 210e2 of the crack stopper 210 so as to overlap at least a portion of the other end 210e2 of the crack stopper 210 and may be configured to be electrically connected to the other end 210e2 of the crack stopper 210. The first connection line 271 may be electrically connected to the second stopper pattern 212 of the crack stopper 210 through the first contact hole 270h1 formed in the third insulating layer 114. For example, the first connection line 271 may be made of a same metal material as the connection electrode 116 illustrated in FIG. 3 and may be formed together with the connection electrode 116.

The second connection line 272 may be disposed on the overcoat layer 115 so as to overlap at least a portion of the first connection line 271 and may be configured to be electrically connected to the first connection line 271. The second connection line 272 may be electrically connected to the first connection line 271 through the second contact hole 270h2 formed in the overcoat layer 115 (or the upper structure 234b of the fourth barrier structure 234). For example, the second connection line 272 may be made of a same metal material as the pixel electrode PE illustrated in FIG. 3 and may be formed together with the pixel electrode PE.

The second connection line 272 may be covered by the first encapsulation layer 151, the third encapsulation layer 153, the touch buffer layer 161, and the touch insulating layer 165. The second connection line 272 may be electrically connected to the second detection line 241b of the crack detection part 240 (or the crack detection electrode 241).

In the crack detection part 240, the second detection line 241b of the crack detection electrode 241 may further include a line contact part 240d electrically connected to the second connection line part 270B of the connection line part 270.

The line contact part 240d of the second detection line 241b may be electrically connected to the second connection line 272 of the second connection line part 270B through a contact hole 240c passing through the first encapsulation layer 151, the third encapsulation layer 153, the touch buffer layer 161, and the touch insulating layer 165 covering the second connection line part 270B. Accordingly, the second detection line 241b of the crack detection electrode 241 of the crack detection part 240 may be electrically connected to the first stopper pattern 211 through the line contact part 240d, the second connection line 272, the first connection line 271, and the second stopper pattern 212. In addition, the second auxiliary detection line 244b of the auxiliary crack detection electrode 244 overlapping the crack detection electrode 241 of the crack detection part 240 is electrically connected to the second detection line 241b through the second via hole 240b, so that the second auxiliary detection line 244b may be electrically connected to the first stopper pattern 211 through the line contact part 241d of the second detection line 241b, the second connection line 272, the first connection line 271, and the second stopper pattern 212.

The display apparatus (or display panel) 10 according to the fifth embodiment of the present disclosure may further include a first link line 248 and a second link line 249.

The first link line 248 may be configured to be electrically connected between the one end 210e1 of the crack stopper 210 and the driving integrated circuit 300. The first link line 248 may extend from the one end 210e1 of the first stopper pattern 211 of the crack stopper 210 and may be configured to connect to the driving integrated circuit 300 via the non-display area IA of the substrate 100.

The second link line 249 may be configured to be connected between the other end 210e2 of the crack stopper 210 and the driving integrated circuit 300. The second link line 249 may extend from the other end 210e2 of the first stopper pattern 211 of the crack stopper 210 and may be configured to connect to the driving integrated circuit 300 via the non-display area IA of the substrate 100. The first link line 248 and the second link line 249 may be arranged parallel to each other in the non-display area IA of the substrate 100.

The driving integrated circuit 300 electrically connected to the first and second link lines 248 and 249 may be configured to measure the resistance values of the crack detection electrode 241 and the auxiliary crack detection electrode 244 through the first link line 248 and the second link line 249 and may detect cracks or moisture penetration based on changes in the measured resistance values, but is not limited thereto. For example, the driving integrated circuit 300 may continuously or periodically apply a preset voltage (or crack detection voltage) to the first and second link lines 248 and 249, and may detect cracks or moisture penetration occurring around the through hole TH based on changes in the applied voltage due to resistance changes of the first and second link lines 248 and 249 caused by the cracks or the moisture. Likewise, the driving integrated circuit 300 may detect cracks or moisture penetration generating around the auxiliary through hole AH based on changes in the applied voltage due to a change in resistance values of the first link line 242 and the second link line 243 of the crack detection part 240 disposed around the auxiliary through hole AH of the hole part HIA.

Referring to FIGs. 14 and 17, the display apparatus (or display panel) 10 according to the fifth embodiment of the present disclosure may further include a bezel crack stopper 250.

The bezel crack stopper 250 may be disposed in the non-display area IA (or a bezel area BZA) of the substrate 100 and may be configured to block (or prevent) propagation (or spreading) of cracks generated from a side surface (or sidewall) of the substrate 100 or generating in the non-display area IA of the substrate 100. In addition, the bezel crack stopper 250 may be configured to detect cracks generated from the side surface of the substrate 100 or generating in the non-display area IA of the substrate 100. The bezel crack stopper 250 is substantially a same as the bezel crack stopper 250 described above with reference to FIGs. 12 and 13, and thus, the same reference numerals are applied, and redundant descriptions are omitted or briefly described. Accordingly, the descriptions of the bezel crack stopper 250 with reference to FIGs. 12 and 13 may be included in the description of FIGs. 14 and 17.

The display apparatus (or display panel) 10 according to the fifth embodiment of the present disclosure may further include a bezel dam structure 260.

The bezel dam structure 260 may be disposed (or configured) along the non-display area IA so as to surround the display area AA of the substrate 100. The bezel dam structure 260 may be disposed (or configured) on the second insulating layer 113. For example, the bezel dam structure 260 may have a closed-curve shape or a frame shape surrounding the display area AA of the substrate 100. The bezel dam structure 260 is substantially a same as the bezel dam structure 260 described above with reference to FIGs. 12 and 13, and thus, the same reference numerals are applied, and redundant descriptions are omitted or briefly described. Accordingly, the descriptions of the bezel dam structure 260 with reference to FIGs. 12 and 13 may be included in the description of FIGs. 14 and 17.

As described above, the display apparatus (or display panel) according to the fifth embodiment of the present disclosure includes the crack stopper 210 and the crack detection part 240, which are disposed in and electrically connected to the hole part HIA, so that cracks generating around the hole part HIA may be detected through the crack detection part 240 while propagation of the cracks is blocked by the crack stopper 210. Furthermore, the display apparatus (or display panel) of the fifth embodiment of the disclosure includes the bezel crack stopper 250, so that cracks generating in the bezel area BZA of the substrate 100 may be detected through the bezel crack stopper 250, and propagation of cracks generating in the bezel area BZA of the substrate 100 may be blocked by the bezel crack stopper 250.

FIG. 18 is a diagram illustrating a display apparatus according to a sixth embodiment of the present disclosure and FIG. 19 is a cross-sectional view taken along line VII-VII' of FIG. 18. The portion "A" illustrated in FIG. 18 is illustrated in FIG. 2, and the portion "E" illustrated in FIG. 18 is illustrated in FIG. 15. FIGs. 18 and 19 illustrate an embodiment where an edge barrier structure is additionally configured at the display apparatus according to the fifth embodiment of the present disclosure described above with reference to FIGs. 14 to 17. In the following description, therefore, only additionally provided edge barrier structure will be described in detail, the other elements are referred to by the same reference numerals as FIGs. 14 to 17, and thus, redundant descriptions are omitted or briefly described. Therefore, descriptions above with reference to FIGs. 14 to 17 may be included in descriptions of FIGs. 18 and 19.

Referring to FIGs. 18 and 19, the display apparatus (or display panel) 10 according to the sixth embodiment of the present disclosure may include all configurations of the display apparatus (or display panel) 10 according to the fifth embodiment of the present disclosure and may further include an edge barrier structure 280.

The edge barrier structure 280 may be configured to block moisture or oxygen penetrating from the side surface of the substrate 100 into inside of the display area AA. The edge barrier structure 280 may be disposed (or configured) in the non-display area IA of the substrate 100. For example, the edge barrier structure 280 may be disposed in the non-display area IA of the substrate 100 to surround at least two corner portions of the display area AA adjacent to the hole part HIA among the corner portions of the display area AA. The edge barrier structure 280 may be configured to include an undercut region or an eave structure for discontinuing the continuity of the light emitting device ED formed in the non-display area IA.

For example, the light emitting device ED formed (or deposited) in the display area AA may be formed by a deposition process (or evaporation deposition process) using a deposition mask. In the deposition process, when misalignment of the deposition mask supported by the spacer SPA occurs, the deposited light emitting device ED may also be formed (or deposited) in the non-display area IA (or bezel area BZA). Since the light emitting device ED formed in the non-display area IA is made of an organic material with highly reactivity to moisture and/or oxygen and high permeability to moisture and/or oxygen, moisture and/or oxygen penetrating into the side surface of the substrate 100 may pass through the light emitting device ED formed in the non-display area IA and may penetrate into the light emitting device ED disposed in the display area AA.

The edge barrier structure 280 may be configured to disconnect (or separate) the light emitting device ED (or the continuity of the light emitting device ED) formed in the non-display area IA (or a bezel area BZA). For example, the edge barrier structure 280 may be a bezel barrier structure, a second disconnection structure, a second separation structure, a second undercut structure, or a second eave structure.

The edge barrier structure 280 according to an embodiment may be disposed (or configured) along the non-display area IA of the substrate 100 so as to surround the display area AA. For example, the edge barrier structure 280 may have a closed-curve shape (or ring shape or frame shape) surrounding the display area AA.

The edge barrier structure 280 according to an embodiment may include one or more first edge barrier structures 281. For example, the edge barrier structure 280 according to an embodiment may include three or more first edge barrier structures 281.

The one or more first edge barrier structures 281 may be disposed (or configured) along the non-display area IA of the substrate 100 so as to surround the display area AA. The one or more first edge barrier structures 281 may include a lower structure 281a and an upper structure 281b.

The lower structure 281a may be formed (or implemented) by patterning the third insulating layer 114. For example, the lower structure 281a may be formed to have a trapezoidal cross-sectional shape having a top surface and a bottom surface wider than the top surface.

The upper structure 281b may be stacked on the lower structure 281a. For example, the upper structure 281b may be formed to have a trapezoidal cross-sectional shape having a top surface and a bottom surface wider than the top surface. The bottom surface of the upper structure 281b may be in direct contact with the top surface of the lower structure 281a.

The upper structure 281b may be made of a same material as the overcoat layer 115. The upper structure 281b may be a portion of the overcoat layer 115 formed in the display area AA (or hole bezel area HBA) that is not removed. For example, the upper structure 281b may have a same height (or thickness) as the overcoat layer 115 including the first overcoat layer 115a and the second overcoat layer 115b, but is not limited thereto. For example, the upper structure 281b may have a same height (or thickness) as the first overcoat layer 115a.

Since the bottom surface of the upper structure 281b is wider than the top surface of the lower structure 281a, the upper structure 281b may have an eave structure with respect to the lower structure 281a, and the lower structure 281a may have an undercut region with respect to the upper structure 281b. Accordingly, the one or more first edge barrier structures 281 including the lower structure 281a and the upper structure 281b may include the eave structure and/or the undercut region.

Since the light emitting device ED formed (or deposited) on the one or more first edge barrier structures 281 has directivity due to the deposition method, the light emitting device ED may be partially disconnected (or separated) by the eave structure or undercut region of the one or more first edge barrier structures 281, and thus, the continuity of the light emitting device ED may be disconnected (or separated) by the one or more first edge barrier structures 281. Accordingly, the one or more first edge barrier structures 281 may block moisture and/or oxygen that penetrates into the hole part HIA and further penetrates into the light emitting device ED disposed in the display area AA through the light emitting device ED formed in the hole bezel area HBA, thereby protecting the light emitting device ED from moisture and/or oxygen penetrating into the hole part HIA.

The edge barrier structure 280 according to an embodiment may further include one or more second edge barrier structures 282. For example, the edge barrier structure 280 according to an embodiment may include two or more second edge barrier structures 282.

The one or more second edge barrier structures 282 may be configured to surround the one or more first edge barrier structures 281. The one or more second edge barrier structures 282 may be disposed (or configured) in an area between the one or more first edge barrier structures 281 and the bezel crack stopper 250. For example, the one or more second edge barrier structures 282 may be disposed (or configured) in an area between the first bezel dam structure 260A and the second bezel dam structure 260B.

The one or more second edge barrier structures 282 may include a lower structure 281a and an upper structure 281b. Except that each of the lower structure 281a and the upper structure 281b of the one or more second edge barrier structures 282 are disposed (or configured) in the area between the one or more first edge barrier structures 281 and the bezel crack stopper 250, each of the lower structure 281a and the upper structure 281b of the one or more second edge barrier structures 282 is substantially a same as each of the lower structure 281a and the upper structure 281b of the one or more first edge barrier structures 281, and thus, the same reference numerals are applied, and redundant descriptions are omitted.

FIGs. 20 to 22 are diagrams illustrating an edge barrier structure according to another embodiment of the present disclosure. FIGs. 20 to 22 illustrate an embodiment where a planar shape of the edge barrier structure described above with reference to FIGs. 18 and 19 is modified. In the following description, therefore, only a planar shape of the edge barrier structure will be described in detail, and thus, redundant descriptions are omitted or briefly described. Therefore, descriptions above with reference to FIGs. 18 and 19 may be included in descriptions of FIGs. 20 to 22.

Referring to FIG. 20, the edge barrier structure 280 according to another embodiment of the present disclosure may be disposed (or configured) in the remaining non-display area IA except for one side of the non-display area adjacent to the bending area BA of the substrate 100 among the non-display area IA.

The edge barrier structure 280 according to another embodiment may be disposed (or configured) along the remaining non-display area IA except for the bending area BA among the non-display area IA. For example, the edge barrier structure 280 may be disposed (or configured) in the second to fourth non-display areas IA2, IA3, and IA4 including each corner portion of the substrate 100 among the non-display area IA of the substrate 100. For example, the edge barrier structure 280 according to another embodiment may have a "∩"-shape (or inverted U-shape) in plan view (or one-dimensionally).

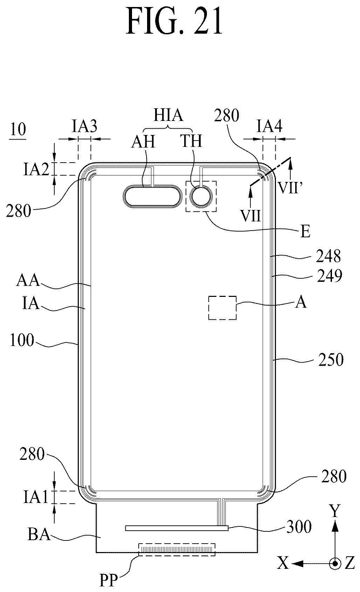

Referring to FIG. 21, the edge barrier structure 280 according to another embodiment of the present disclosure may be disposed (or configured) to surround only the corner portions of the display area AA. For example, the edge barrier structure 280 may be disposed (or configured) in each corner portion of the non-display area IA adjacent to each corner portion of the display area AA to have a curved shape. For example, the edge barrier structure 280 may be disposed (or configured) to have a curved shape surrounding the corner portions between the first to fourth non-display areas IA1, IA2, IA3, and IA4.

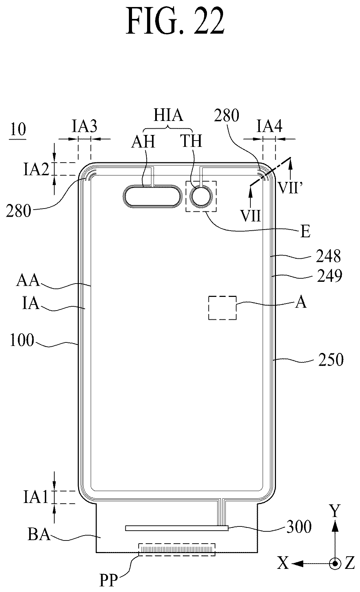

Referring to FIG. 22, the edge barrier structure 280 according to another embodiment of the present disclosure may be disposed (or configured) to surround only the corner portions of one side edge portion of the display area AA. For example, the edge barrier structure 280 may be disposed (or configured) to have a curved shape at the corner portions between each of the third non-display area IA3 and the fourth non-display area IA4 and the second non-display area IA2.

As described above, the display apparatus (or display panel) according to the sixth embodiment of the present disclosure may have a same effects as the display apparatus (or display panel) according to the fifth embodiment of the present disclosure. Furthermore, the display apparatus (or display panel) according to the sixth embodiment of the present disclosure may further include the edge barrier structure 280 that disconnects the continuity of the light emitting device ED disposed in the non-display area IA (or bezel area BZA) of the substrate 100, thereby preventing moisture penetration and color defects in the bezel area BZA of the substrate 100.

The edge barrier structure 280 described above with reference to FIGs. 18 to 22 may be equally applied to the display apparatus 10 (or display panel) according to one or more embodiments of the first to fourth embodiments of the present disclosure described above with reference to FIGs. 1 to 13.

The display apparatus according to an embodiment of the present disclosure may be applied to all electronic devices including light emitting devices. For example, the display apparatus according to an embodiment of the present disclosure may be applied to or included in mobile apparatuses, video phones, smart watches, watch phones, wearable apparatuses, foldable apparatuses, rollable apparatuses, bendable apparatuses, flexible apparatuses, curved apparatuses, electronic organizers, electronic books, portable multimedia players (PMPs), personal digital assistants (PDAs), MP3 players, mobile medical devices, desktop personal computers (PCs), laptop PCs, netbook computers, workstations, navigation apparatuses, automotive navigation apparatuses, automotive display apparatuses, TVs, wall paper display apparatuses, signage apparatuses, game machines, notebook computers, monitors, cameras, camcorders, and home appliances, or the like.

It will be apparent to those skilled in the art that various modifications and variations can be made in the present disclosure without departing from the scope of the disclosures. Thus, it is intended that the disclosure covers the modifications and variations of this disclosure provided that within the scope of the claims and their equivalents.

The various embodiments described above can be combined to provide further embodiments. These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A display apparatus, comprising:
a substrate (100) having a display area (AA) including a hole part (HIA) and a hole bezel area (HBA) adjacent to the hole part (HIA), and a non-display area (IA) adjacent to the display area (AA);
a pixel circuit (PC) disposed in the display area (AA);
an overcoat layer (115) covering the pixel circuit (PC);
a light emitting device (ED) disposed on the overcoat layer (115); and
a crack stopper (210) disposed in the hole bezel area (HBA) of the substrate (100) so as to surround the hole part (HIA),
wherein the crack stopper (210) is configured to form a vertical wall between the substrate (100) and the overcoat layer (115).

2. The display apparatus of claim 1, further comprising:
a buffer layer (111) disposed on the substrate (100);
a pixel circuit layer including the pixel circuit (PC) disposed on the buffer layer (111) in the display area (AA) and a pixel insulating layer (112, 113, 114) insulating the pixel circuit (PC);
a light emitting device layer (118) including the light emitting device (ED) disposed on the overcoat layer (115).

3. The display apparatus of claim 1 or 2, wherein the crack stopper (210) comprises:
a first stopper pattern (211) disposed on the substrate (100), and
a second stopper pattern (212) penetrating the pixel insulating layer and electrically connected to the first stopper pattern (211),
preferably the first stopper pattern (211) is formed of a same metal material as a light shielding pattern disposed between the substrate (100) and the buffer layer (115).

4. The display apparatus of claim 2 or 3, wherein the pixel insulating layer comprises:
a first insulating layer (112) covering an active layer (ACT),
a second insulating layer (113) covering a gate electrode (GE), and
a third insulating layer (114) covering a source and drain electrodes (DE, SE), and
the second stopper pattern (212) is disposed on the third insulating layer (114), is formed of a same metal material as the source electrode (SE), and is configured to form the vertical wall between the substrate (100) and the third insulating layer (114).

5. The display apparatus of any one of the preceding claims, further comprising a crack detection part (240) configured to detect cracks generated in the hole bezel area (HBA) of the substrate (100), preferably the display apparatus further comprising:
an encapsulation part (150) covering the light emitting device layer (118); and
a touch sensing part (160) disposed on the encapsulation part (150) in the display area (AA),
wherein the crack detection part (240) is disposed on the encapsulation part (150) in the hole bezel area (HBA) together with the touch sensing part (160).

6. The display apparatus any one of the preceding claims, wherein the hole part (HIA) is a through hole (TH) configured to penetrate the substrate (100), the buffer layer (111), the pixel circuit layer, the overcoat layer (115), the light emitting device layer (118), the encapsulation part (150), and the touch sensing part (160).

7. The display apparatus of claim 5 or 6, wherein the crack detection part (240) includes a crack detection electrode (241) between one end and the other end of crack detection part (240), preferably the crack detection electrode (240) includes a plurality of curved surfaces disposed in the hole bezel area (HBA) to surround the through hole (TH),
preferably the crack detection electrode (240) comprises:
a first detection line (241a) electrically connected to the one end of the crack detection part (240),
a second detection line (241b) electrically connected to the other end of the crack detection part (240), and
a curved detection line (241c) connecting the first detection line (241a) and the second detection line (241b).

8. The display apparatus of any one of the preceding claims, further comprising a connection line part (270) electrically connecting the crack detection part (240) and the crack stopper (210),

9. The display apparatus of claim 7 or 8, further comprising an auxiliary crack detection electrode (244) electrically connected in parallel to the crack detection electrode (241), preferably the auxiliary crack detection electrode (244) comprises:
a first auxiliary detection line (244a) overlapping the first detection line (241a) and electrically connected to the first detection line (241a),
a second auxiliary detection line (244b) overlapping the second detection line (241b) and electrically connected to the second detection line (241b), and
an auxiliary curved detection line (244c) overlapping the curved detection line (241c) and connected between the first auxiliary detection line (244c) and the second auxiliary detection line (244b).

10. The display apparatus of claim 8 or 9, wherein:
the crack stopper (210) includes an opening portion between the one end and the other end, and the connection line part (270) includes:
a first connection line part (270A) electrically connecting the first detection line (241a) and the one end of the crack stopper (210), and
a second connection line part (270B) electrically connecting the second detection line (241b) and the other end of the crack stopper (210),
preferably the first connection line part (270A) includes:
a first connection line (271) electrically connected to the one end of the crack stopper (210), and
a second connection line (272) electrically connecting the first detection line (241a) and the first connection line (271), and
the second connection line part (270B) includes:
a third connection line electrically connected to the other end of the crack stopper (210), and
a fourth connection line electrically connecting the second detection line (241b) and the third connection line.

11. The display apparatus of any one of the preceding claims, further comprising at least one of:
a driving integrated circuit (300) disposed in the non-display area (IA) of the substrate (100) and connected to the pixel circuit (PC);
a first link line (242) electrically connected to the driving integrated circuit (300), and
a second link line (243) electrically connected to the driving integrated circuit (300),
wherein the driving integrated circuit (300) is configured to measure a change in resistance values between the first link line (242) and the second link line (243);
a stopper power line (217) electrically connected between the first stopper pattern (211) and the driving integrated circuit (300), preferably the stopper power line (217) is electrically connected to a ground terminal or a high-potential power terminal of the driving integrated circuit (300).

12. The display apparatus of any one of the preceding claims, further comprising an edge barrier structure (280) disposed in the non-display area (IA) of the substrate (100), wherein the edge barrier structure (280) includes an undercut region or an eave structure for discontinuing the continuity of the light emitting device (ED) formed in the non-display area (IA), preferably the edge barrier structure (280) surrounds at least two corners of the display area (AA) adjacent to the hole part (HIA) among corners of the display area (AA).

13. The display apparatus of any one of the preceding claims, further comprising a bezel crack stopper (250) disposed along the non-display area (IA) of the substrate (100), preferably the bezel crack stopper (250) forms a bezel partition wall between the substrate (100) and the touch sensing part (160).

14. The display apparatus any one of the preceding claims, further comprising a bezel crack stopper (250) disposed along the non-display area (IA) of the substrate (100), preferably the driving integrated circuit (300) is electrically connected to each of the pixel circuit (PC), the crack stopper (210), and the bezel crack stopper (250), wherein the driving integrated circuit (300) is configured to measure a change in resistance values of each of the crack detection part (240) and the bezel crack stopper (250).

15. The display apparatus of claim 14, wherein the bezel crack stopper (250) comprises:
a first metal pattern (251) disposed between the substrate (100) and the buffer layer (111),
a second metal pattern (252) electrically connected to the first metal pattern (251), and
a third metal pattern (253) disposed at the touch sensing part (160) and electrically connected to the second metal pattern (252), the second metal pattern (252) and the third metal pattern (253) form the bezel partition wall.
